(19) Europäisches Patentamt
European Patent Office
Office européen des brevets

(11) **EP 3 764 064 B1**

(12) **EUROPÄISCHE PATENTSCHRIFT**

(45) Veröffentlichungstag und Bekanntmachung des Hinweises auf die Patenterteilung:
**07.09.2022 Patentblatt 2022/36**

(21) Anmeldenummer: **20165218.7**

(22) Anmeldetag: **24.03.2020**

(51) Internationale Patentklassifikation (IPC):
**G01D 5/244** *(2006.01)* **G01D 5/347** *(2006.01)*
**H03M 1/30** *(2006.01)*

(52) Gemeinsame Patentklassifikation (CPC):
**G01D 5/3473; G01D 5/24471; G01D 5/34792;**
**H03M 1/1009; H03M 1/308;** G01D 2205/90

(54) **OPTISCHE POSITIONSMESSEINRICHTUNG**

OPTICAL POSITIONING DEVICE

DISPOSITIF OPTIQUE DE MESURE DE POSITION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.07.2019 DE 102019210274**

(43) Veröffentlichungstag der Anmeldung:
**13.01.2021 Patentblatt 2021/02**

(73) Patentinhaber: **Dr. Johannes Heidenhain GmbH 83301 Traunreut (DE)**

(72) Erfinder:
• **HOLZAPFEL, Wolfgang**
**83119 Obing (DE)**
• **FRESE, Daniel**
**83278 Traunstein (DE)**
• **LINGK, Christoph**
**83278 Traunstein (DE)**

(56) Entgegenhaltungen:
**EP-A2- 2 662 666 DE-T5-112005 002 253**
**US-A- 3 544 800 US-A1- 2007 075 230**

**Beschreibung**

GEBIET DER TECHNIK

Die vorliegende Erfindung betrifft eine optische Positionsmesseinrichtung zur Erfassung des Drehwinkels zwischen zwei zueinander rotatorisch beweglichen Objekten.

STAND DER TECHNIK

Derartige Positionsmesseinrichtungen besitzen in der Regel eine um eine Rotationsachse rotierende Gitter-Maßverkörperung, angeordnet auf einer sogenannten Teilscheibe. Die Gitter-Maßverkörperung ist üblicherweise als Radialteilung ausgebildet, aus deren Abtastung mittels einer geeigneten Abtasteinheit Positionssignale bzgl. der Rotationsbewegung der Teilscheibe erzeugbar sind; die derart erzeugten Positionssignale charakterisieren den azimutalen Drehwinkel zwischen den beiden zueinander rotatorisch beweglichen Objekten. Die erforderliche Abtasteinheit umfasst hierzu u.a. mindestens eine geeignet ausgebildete optoelektronische Detektoranordnung. Mit der rotierenden Teilscheibe einerseits und dem demgegenüber stationären Teil der Positionsmesseinrichtung andererseits, d.h. der Abtasteinheit, sind die beiden Objekte verbunden, deren Position bzw. winkelmäßige Relativorientierung zueinander zu bestimmen ist. In einer typischen Anwendung wird über eine solche Positionsmesseinrichtung z.B. die Drehbewegung einer rotierenden Antriebswelle gegenüber dem hierzu stationären Antriebsgehäuse bestimmt. Die darüber erfassten Positionssignale bzw. Drehwinkel können in bekannter Art und Weise zur Antriebsregelung herangezogen werden.

Probleme ergeben sich nunmehr insbesondere, wenn die rotierende Teilscheibe und die demgegenüber stationären Komponenten der Positionsmesseinrichtung nicht bereits werksseitig zueinander montiert werden, sondern beispielsweise eine Montage der separat gelieferten Teilscheibe und der Abtasteinheit(en) kundenseitig erfolgt. Es ist in diesem Fall dann nicht ohne weiteres gewährleistet, dass die Teilscheibe und damit die abgetastete Gitter-Maßverkörperung exakt zentriert zur tatsächlichen Drehachse montiert wird. Dies stellt aber eine maßgebliche Voraussetzung bei der Auswertung der erzeugten Positionssignale dar. In der Praxis resultieren demzufolge oftmals Positionssignale, die mit sogenannten Exzentrizitätsfehlern behaftet sind; diese sind auf das Nicht-Zusammenfallen der tatsächlichen Drehachse mit der Achse der rotierenden Teilscheibe bzw. Gitter-Maßverkörperung zurückzuführen und bewegen sich in der Größenordnung der Exzentrizität. Die durch eine exzentrische Lagerung der Teilscheibe verursachten Fehler sind bei kundenseitiger Montage erheblich und beeinflussen maßgeblich die maximale Messgenauigkeit der entsprechenden Positionsmesseinrichtungen.

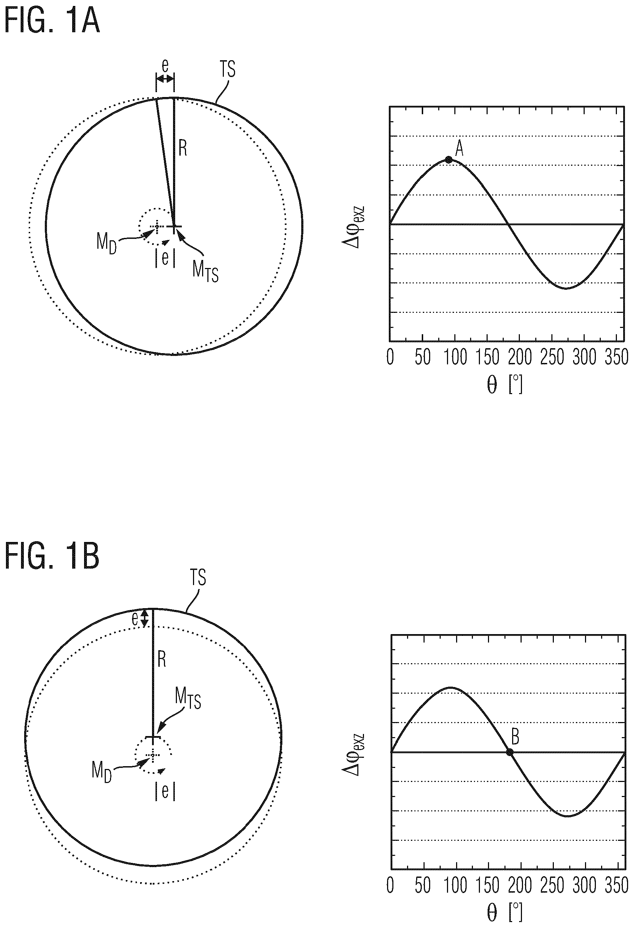

Anhand der Darstellungen in den Figuren 1A - 1D werden die entsprechenden Zusammenhänge nachfolgend im Detail erläutert. Die Figuren zeigen jeweils eine um die Drehachse $M_D$ rotierende Teilscheibe TS in verschiedenen Rotationsstellungen A - D, wobei die Achse $M_{TS}$ der Gitter-Maßverkörperung bzw. Teilscheibe TS eine Exzentrizität e gegenüber der Drehachse $M_D$ aufweist. Ferner ist in den Figuren jeweils der exzentrizitätsbedingte Drehwinkel-Fehler $\Delta\varphi_{exz}(\Theta)$ bei der entsprechenden Rotationsstellung A - D der Teilscheibe TS angegeben. Nicht dargestellt ist in den Figuren die Gitter-Maßverkörperung auf der Teilscheibe TS, die als Radialteilung ausgebildet und als kreisringförmige Teilungsspur im mittleren Abtastradius R um die Achse $M_{TS}$ der Gitter-Maßverkörperung bzw. Teilscheibe TS angeordnet ist.

Am Abtastort der Gitter-Maßverkörperung ergibt sich in einem solchen Fall die tangentiale Verschiebung $\Delta t(\Theta)$ der Teilscheibe TS folgendermaßen:

$$\Delta t(\theta) = e \cdot \sin(\theta + \Delta\theta_1) \qquad \text{(Gl. 1)}$$

mit:

   $\Delta t(\Theta)$ := tangentiale Verschiebung der Teilscheibe
   $\theta$ := Drehwinkel der Teilscheibe
   e := Exzentrizität
   $\Delta\Theta_1$ := Phasenlage des exzentrizitätsbedingten Drehwinkel-Fehlers

Die azimutale Abtastung der Gitter-Maßverkörperung auf der Teilscheibe TS liefert einen Drehwinkel-Wert $\varphi_{mess}(\Theta)$, der einen Drehwinkel-Fehler $\Delta\varphi_{exz}(\Theta)$ aufgrund der vorliegenden Exzentrizität e gemäß folgender Beziehung aufweist:

$$\varphi_{mess}(\theta) = \theta + \Delta\varphi_{exz}(\theta) \qquad \text{(Gl. 2)}$$

wobei

$$\Delta\varphi_{exz}(\theta) = \frac{\Delta t(\theta)}{R} = \frac{e}{R} \cdot \sin(\theta + \Delta\theta_1) \qquad \text{(Gl. 3)}$$

mit:

$\varphi_{mess}(\Theta)$ := Drehwinkel-Wert der azimutalen Abtastung
$\Delta\varphi_{exz}(\Theta)$ := exzentrizitätsbedingter Drehwinkel-Fehler
$\theta$ := Drehwinkel der Teilscheibe
$e$ := Exzentrizität
$\Delta\Theta_1$ := Phasenlage des exzentrizitätsbedingten Drehwinkel-Fehlers
$R$ := Abtastradius

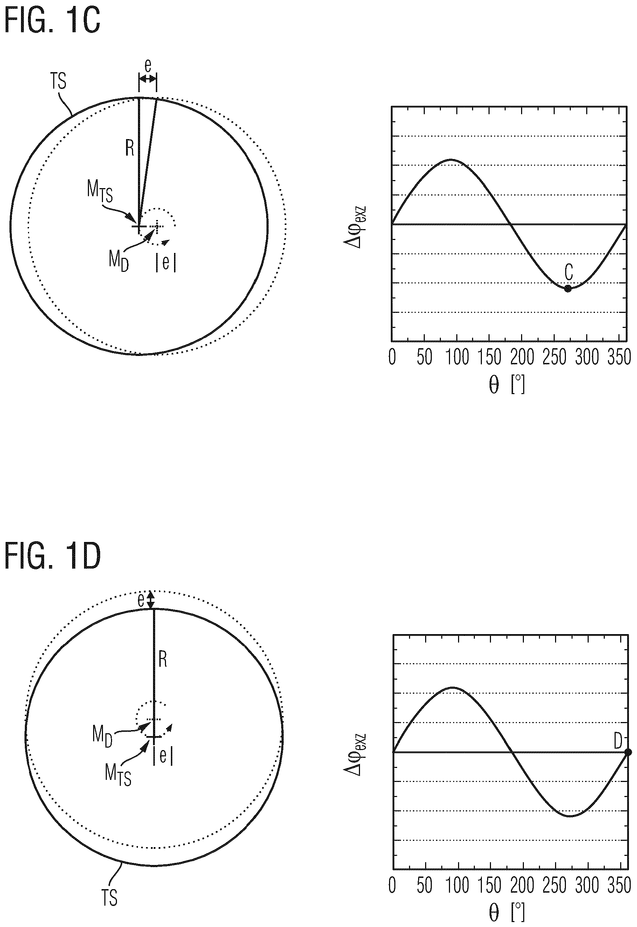

Wie aus den Figuren 1A - 1D sowie Gleichung 3) ersichtlich, ist der exzentrizitätsbedingte Drehwinkel-Fehler $\Delta\varphi_{exz}(\Theta)$ periodisch und wiederholt sich mit der Periodizität einer vollen Umdrehung der Teilscheibe TS. In den Rotations-Stellungen A und C der Teilscheibe TS gemäß den Figuren 1A und 1C ist der exzentrizitätsbedingte Drehwinkel-Fehler $\Delta\varphi_{exz}(\Theta)$ maximal, in den Rotations-Stellungen B und D der Teilscheibe TS verschwindet gemäß den Figuren 1B und 1D der exzentrizitätsbedingte Drehwinkel-Fehler $\Delta\varphi_{exz}(\Theta)$.

Zur Eliminierung von Exzentrizitätsfehlern in rotatorischen Positionsmesseinrichtungen sind bereits eine Vielzahl von Lösungen vorgeschlagen worden. Einer der hierzu bekannt gewordenen Lösungsansätze gemäß der DE 11 2005 002 253 T5 sieht etwa vor, dass auf der rotierenden Teilscheibe neben der zur Erfassung der Rotationsbewegung genutzten kreisringförmigen Teilungsspur mit einer Radialteilung und einer zugehörigen Detektionseinheit bzw. Abtaststelle parallel eine weitere kreisringförmige Teilungsspur angeordnet wird, die aus konzentrisch und kreisringförmig angeordneten Teilungs- bzw. Gitterlinien besteht. Über eine, der zusätzlichen Teilungsspur zugeordneten weiteren Detektionseinheit an der gleichen Azimut-Position wie die erste Detektionseinheit kann eine eventuell vorliegende Auslenkung der Teilscheibe in radialer Richtung quantitativ erfasst und zur Korrektur der eigentlich interessierenden Positionssignale bzw. Drehwinkel genutzt werden, die die Rotation der Teilscheibe um die Rotationsachse beschreiben.

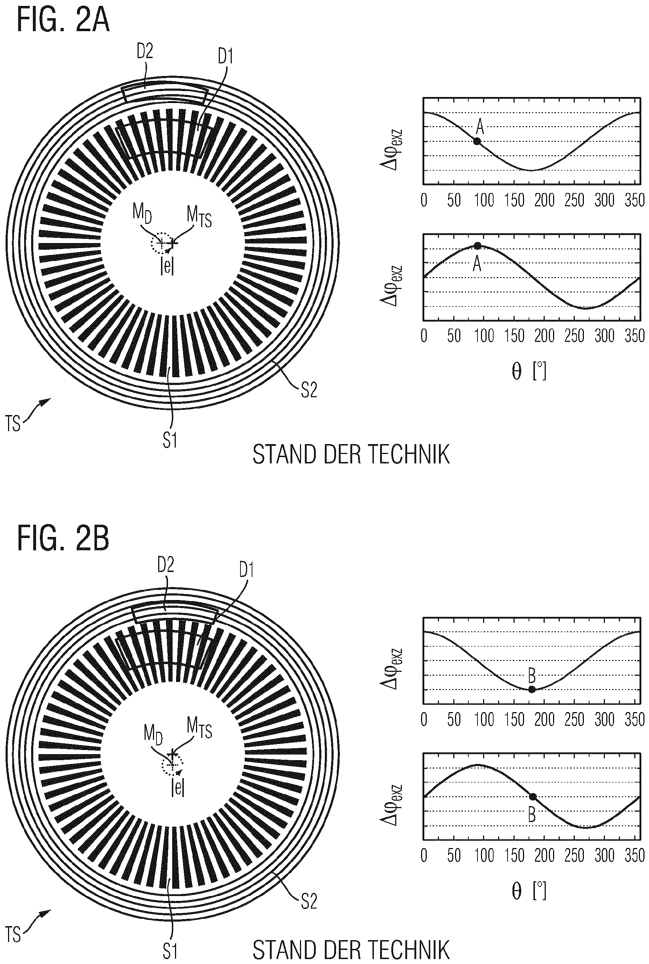

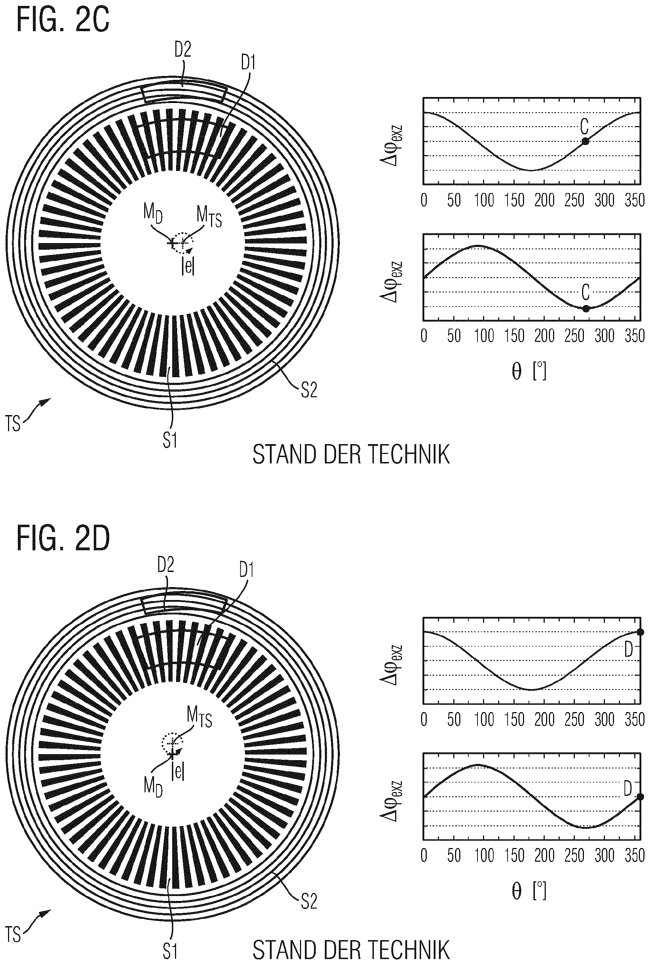

Nachfolgend sei mit Hilfe der Figuren 2A - 2D das der DE 11 2005 002 253 T5 zugrundeliegende Prinzip zur Korrektur von Exzentrizitätsfehlern erläutert. Die entsprechenden Figuren zeigen jeweils die verwendete Teilscheibe TS mit zwei genutzten Teilungsspuren S1, S2 und den zugehörigen Detektionseinheiten D1, D2 in verschiedenen Rotations-Stellungen A - D, wobei die Achse $M_{TS}$ der Gitter-Maßverkörperung bzw. Teilscheibe TS eine Exzentrizität $e$ gegenüber der Drehachse $M_D$ aufweist. Zur jeweiligen Rotations-Stellung A - D sind in den Figuren 2A - 2D noch jeweils die exzentrizitätsbedingten Auslenkungen $\Delta r_{exz}(\Theta)$ der Teilscheibe TS in radialer Richtung (obere Darstellung) und die exzentrizitätsbedingten Drehwinkel-Fehler $\Delta\varphi_{exz}(\Theta)$ (untere Darstellung) angegeben.

Im Fall einer exzentrischen Bewegung der Teilscheibe TS ist deren radiale Auslenkung $\Delta r_{exz}(\Theta)$ mit der tangentialen Verschiebung $\Delta t(\Theta)$ durch folgende Beziehung verknüpft:

$$\Delta r_{exz}(\theta) = \Delta t(\theta + \frac{\pi}{2}) \qquad \text{(Gl. 4)}$$

mit:

$\Delta r_{exz}(\Theta)$ := radiale Auslenkung der Teilscheibe
$\Delta t(\Theta)$ := tangentiale Verschiebung der Teilscheibe
$\theta$ := Drehwinkel der Teilscheibe

Für den exzentrizitätsbedingten Drehwinkel-Fehler $\Delta\varphi_{exz}(\Theta)$ gilt daher

$$\Delta\varphi_{exz}(\theta) = \frac{1}{R} \cdot \Delta r_{exz}(\theta - \frac{\pi}{2}) \qquad \text{(Gl. 5)}$$

mit:

$\Delta\varphi_{exz}(\Theta)$ := exzentrizitätsbedingter Drehwinkel-Fehler
$\Delta r_{exz}(\Theta)$ := radiale Auslenkung der Teilscheibe
$R$ := Abtastradius
$\theta$ := Drehwinkel der Teilscheibe

Aus den Figuren 2A - 2D ist ersichtlich, dass der über die Abtastung der kreisringförmig angeordneten Teilungslinien in der Teilungsspur S2 erhaltene Messwert der radialen Teilscheiben-Auslenkung $\Delta r_{exz}(\Theta)$ zum exzentrizitätsbedingten Drehwinkel-Fehler $\Delta\varphi_{exz}(\Theta)$ genau um 90° phasenverschoben ist. Diesen Zusammenhang kann man für eine Korrektur nutzen, indem man in einem Kalibrierbetrieb nach der Montage der Teilscheibe TS den Messwert der radialen Teilscheiben-Auslenkung $\Delta r_{exz}(\Theta)$ für eine volle Umdrehung der Teilscheibe TS aufnimmt, diesen weiterverarbeitet und dabei mit dem Faktor 1/R skaliert und als drehwinkelabhängigen Korrekturwert $\varphi_{korr}(\Theta)$ z.B. in einer Tabelle abspeichert:

$$\varphi_{korr}(\theta) = \frac{1}{R} \cdot \Delta r_{exz}(\theta) \qquad \text{(Gl. 6)}$$

mit:

$\varphi_{korr}(\Theta)$ := drehwinkelabhängiger Korrekturwert
$\Delta r_{exz}(\Theta)$ := radiale Auslenkung der Teilscheibe
R := Abtastradius
$\theta$ := Drehwinkel der Teilscheibe

Der tatsächlich ausgegebene und korrigierte Winkelposition $\varphi_{out}$ wird im Messbetrieb dann mit einem um 90° versetzten Korrekturwert $\varphi_{korr}(\Theta)$ aus der Tabelle korrigiert.

Diese Vorgehen ist insofern vorteilhaft, da hierbei kein externes Referenzsystem für die Kalibrierung des azimutalen Drehwinkel-Werts benötigt wird, sondern die Positionsmesseinrichtung alle nötigen Korrektur-Informationen selber ermittelt.

Für optische Positionsmesseinrichtungen, die im Durchlicht arbeiten, können auf diese Art und Weise die durch eine eventuelle Exzentrizität der Teilscheibe bzw. Gitter-Maßverkörperung verursachten Messfehler auf einfache Art und Weise korrigiert werden. Insbesondere im Fall rotatorischer, optischer Positionsmesseinrichtungen mit einer Auflichtabtastung resultieren jedoch noch weitere Fehler, die die Messgenauigkeit erheblich beeinträchtigen können. Derartige Fehler werden durch eine eventuelle Taumelbewegung der Teilscheibe verursacht, wenn diese nicht ideal angeordnet bzw. gelagert ist. Im Hinblick auf die Korrektur derartiger Fehler, enthält die DE 11 2005 002 253 T5 keine Lösungsansätze.

In der EP 2 662 666 A2 wird ein Vorgehen vorgeschlagen, um in einer rotatorischen Positionsmesseinrichtung Exzentrizitäts- und/oder Taumelfehler, die durch eine Verschlechterung der Lagerqualität bedingt sind, von Fehlern zu unterscheiden, die durch eine Verschmutzung der Maßverkörperung verursacht werden. Hierzu erfolgt die Erfassung und Auswertung von Messgrößen wie z.B. der Signalamplitude für eine Mehrzahl unterschiedlicher Relativpositionen von Maßverkörperung und Abtasteinheit.

Aus der US 2007/0075230 A1 ist bekannt, Exzentrizitäts- und Taumelfehler in einer rotatorischen Positionsmesseinrichtung über zwei separate Abtastungen zu ermiteln, die jeweils eine Lichtquelle und einen optischen Sensor umfassen.

## ZUSAMMENFASSUNG DER ERFINDUNG

Der vorliegenden Erfindung liegt die Aufgabe zugrunde, eine optische Positionsmesseinrichtung zur Erfassung rotatorischer Relativbewegungen anzugeben, in der neben exzentrizitätsbedingten Fehlern bei der DrehwinkelBestimmung auch Fehler kompensierbar sind, die durch einen Taumel der abgetasteten Gitter-Maßverkörperung bzw. Teilscheibe verursacht werden.

Diese Aufgabe wird erfindungsgemäß durch eine optische Positionsmesseinrichtung mit den Merkmalen des Anspruchs 1 gelöst.

Vorteilhafte Ausführungsformen der vorliegenden Erfindung ergeben sich aus den Maßnahmen, die in den abhängigen Ansprüchen aufgeführt sind.

Die erfindungsgemäße optische Positionsmesseinrichtung zur Erfassung des Drehwinkels zwischen zwei zueinander rotatorisch beweglichen Objekten umfasst eine um eine Drehachse rotierende Gitter-Maßverkörperung, die als Reflexionsgitter ausgebildet ist und aus deren Abtastung sowohl Positionsinformationen bezüglich einer azimutalen Drehbewegung um die Drehachse als auch bezüglich einer radialen Verschiebung der Gitter-Maßverkörperung erzeugbar sind. Ferner ist mindestens eine Detektionseinheit zur Abtastung der rotierenden Gitter-Maßverkörperung vorgesehen, die dazu eingerichtet ist, eine radiale Abtastung sowie eine azimutale Abtastung durchzuführen, wodurch der azimutale Drehwinkel sowie eine radiale Verschiebung der Gitter-Maßverkörperung bestimmt werden. Hierbei liegen die neutrale Drehachse der Abtastung der Gitter-Maßverkörperung zur Drehwinkelbestimmung und die neutrale Drehachse der Abtastung zur Verschiebungsbestimmung in dergleichen Ebene, wobei diese Ebene parallel zur unverkippten Gitter-Maßverkörperung liegt und eine neutrale Drehachse diejenige Drehachse bezeichnet, um die die Gitter-Maßverkörperung und die Detektionseinheit gegeneinander verkippbar sind und dabei die jeweils gemessene Position unverändert bleibt.

Es ist möglich, dass die Gitter-Maßverkörperung eine Radial-Teilung sowie eine hierzu benachbart angeordnete Kreisring-Teilung umfasst.

Dabei kann eine erste Detektionseinheit zur Abtastung der Radial-Teilung und eine zweite Detektionseinheit zur Abtastung der Kreisring-Teilung dienen.

**Fortsetzung: Ursprüngliche Seite 8**

Desweiteren ist möglich, dass die Gitter-Maßverkörperung aus kreisringförmig und periodisch mit einer ersten Maßverkörperungs-Periodizität angeordneten Streifenelementen besteht, deren Längserstreckungsrichtung radial orientiert ist und wobei die Streifenelemente zur Absolutpositionscodierung entlang ihrer Längserstreckungsrichtung eine periodische Struktur mit einer zweiten Maßverkörperungs-Periodizität besitzen.

Hierbei umfasst die Detektionseinheit vorzugsweise eine einzige Lichtquelle sowie eine einzige Detektoranordnung.

Die Detektoranordnung kann als zweidimensionale Detektoranordnung mit einer Mehrzahl von Detektorelementen ausgebildet sein und mehrere Detektorspalten mit jeweils mehreren Detektorelementen aufweisen, wobei die Detektorspalten entlang der kreisringförmigen Anordnungsrichtung mit einer ersten Detektions-Periodizität periodisch angeordnet sind und die Detektorelemente in den Detektorspalten mit einer zweiten Detektions-Periodizität periodisch angeordnet sind.

Mit Vorteil ist die optische Abtastung der Gittermaßverkörperung als Zentralprojektions-Abtastung mit dem Abbildungsmaßstab $\beta = 2$ ausgebildet und umfasst eine divergente Lichtquelle sowie eine Detektoranordnung, welche entlang mindestens einer Richtung periodisch ausgebildet ist.

Desweiteren ist möglich, dass die optische Positionsmesseinrichtung eine Signalverarbeitungseinheit aufweist, die derart eingerichtet und ausgebildet ist,

- dass die in einem Kalibrierbetrieb über mindestens eine vollständige Umdrehung der Gitter-Maßverkörperung gewonnenen, drehwinkelabhängigen Messwerte zu einer radialen Verschiebung der Gitter-Maßverkörperung weiterverarbeitet und als drehwinkelabhängige Korrekturwerte in einem Speicher der Signalverarbeitungseinheit ablegbar sind, und
- dass im Messbetrieb die im Speicher abgelegten drehwinkelabhängigen Korrekturwerte von der Signalverarbeitungseinheit herangezogen werden, um den gemessenen azimutalen Drehwinkel bezüglich vorliegender Exzentrizitäts- und Taumelfehler zu korrigieren.

Hierbei kann die die Signalverarbeitungseinheit derart eingerichtet und ausgebildet sein, um die im Kalibrierbetrieb gewonnenen, drehwinkelabhängigen Messwerte zu einer radialen Verschiebung der Gitter-Maßverkörperung von der Signalverarbeitungseinheit im Messbetrieb zur Korrektur eines um 90° versetzten Drehwinkels bezüglich vorliegender Exzentrizitäts- und Taumelfehler zu nutzen.

Vorzugsweise korrigiert die Signalverarbeitungseinheit den Drehwinkel bezüglich vorliegender Exzentrizitäts- und Taumelfehler folgendermaßen:

$$\varphi_{out} = \varphi_{mess} - \varphi_{korr}(\varphi_{mess} - \pi/2)$$

mit:

$\varphi_{out}$ := ausgegebene, korrigierte Winkelposition
$\varphi_{mess}(\Theta)$ := Drehwinkel-Wert der azimutalen Abtastung
$\varphi_{korr}(\Theta)$ := drehwinkelabhängiger Korrekturwert

Über die erfindungsgemäßen Maßnahmen kann der von der Positionsmesseinrichtung gemessene Drehwinkel sowohl bezüglich eventuell vorliegender Exzentrizitäts- als auch gleichzeitig bezüglich eventueller Taumelfehler der Gitter-Maßverkörperung bzw. Teilscheibe korrigiert werden. Letztere stellen insbesondere bei optischen Positionsmesseinrichtungen mit Auflichtabtastung eine nicht zu vernachlässigende Fehlerquelle dar.

In einer besonders vorteilhaften Ausführungsform mit einer speziell ausgebildeten Gitter-Maßverkörperung können die hierzu erforderlichen Informationen aus einer einzigen Abtaststelle gewonnen werden. Es resultiert eine sehr kompakte Bauform der entsprechenden Positionsmesseinrichtung.

Weitere Einzelheiten und Vorteile der vorliegenden Erfindung seien anhand der nachfolgenden Beschreibung von Ausführungsbeispielen der erfindungsgemäßen Vorrichtung in Verbindung mit den Figuren erläutert.

## KURZE BESCHREIBUNG DER ZEICHNUNGEN

Es zeigt

| | |
|---|---|
| Figur 1A - 1D | jeweils eine Darstellung einer exzentrisch angeordneten Teilscheibe in verschiedenen Rotationsstellungen sowie die jeweils zugehörigen, exzentrizitätsbedingten Winkelabweichungen; |
| Figur 2A - 2D | jeweils eine Darstellung einer exzentrisch angeordneten Teilscheibe mit einer zusätzlichen Teilungsspur in verschiedenen Rotationsstellungen gemäß dem Stand der Technik sowie die jeweils zugehörigen radiale Teilscheiben-Auslenkungen und Drehwinkel-Fehler; |
| Figur 3 | eine Darstellung zur Erläuterung der Verhältnisse im Fall einer taumelnden Teilscheibe bei einer Auflicht-Abtastung; |
| Figur 4A - 4D | jeweils eine Darstellung zur Erläuterung des Einflusses einer taumelnden Teilscheibe auf den gemessenen Drehwinkel, angelehnt an die Darstellungen in den Figuren 1A - 1D; |
| Figur 5 | eine Darstellung zu den durch Exzentrizität und Taumel verursachten Fehlern im gemessenen Drehwinkel; |
| Figur 6A - 6C | jeweils eine Darstellung zur Erläuterung des neutralen Drehpunkts bei einer ersten Abtastungsvariante; |
| Figur 7A - 7C | jeweils eine Darstellung zur Erläuterung des neutralen Drehpunkts bei einer zweiten Abtastungsvariante; |
| Figur 8A, 8B | jeweils schematische Darstellungen zur Erläuterung des Vorgehens im Kalibrier- und Messbetrieb der erfindungsgemäßen Positionsmesseinrichtung; |
| Figur 9A | eine Draufsicht auf die Teilscheibe eines ersten Ausführungsbeispiels einer erfindungsgemäßen Positionsmesseinrichtung; |
| Figur 9B | eine Schnittansicht des ersten Ausführungsbeispiels einer erfindungsgemäßen Positionsmesseinrichtung; |
| Figur 10A | eine Draufsicht auf die Teilscheibe eines zweiten Ausführungsbeispiels einer erfindungsgemäßen Positionsmesseinrichtung; |
| Figur 10B | eine Schnittansicht des zweiten Ausführungsbeispiels einer erfindungsgemäßen Positionsmesseinrichtung. |

## BESCHREIBUNG DER AUSFÜHRUNGSFORMEN

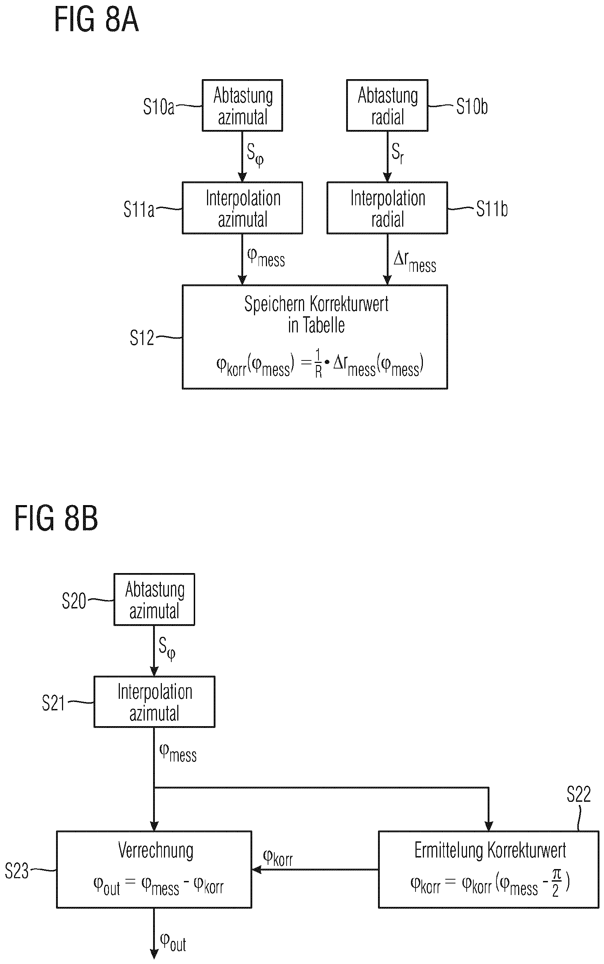

Bevor konkrete Ausführungsbeispiele der erfindungsgemäßen optischen Positionsmesseinrichtung anhand der Figuren 8A, 8B, 9A, 9B, 10A und 10B beschrieben werden, seien zunächst verschiedene theoretische Überlegungen im Zusammenhang mit der vorliegenden Erfindung erläutert.

Rotatorische optische Positionsmesseinrichtungen, deren Gitter-Maßverkörperungen im Durchlicht abgetastet werden, weisen gemäß der oben diskutierten DE 11 2005 002 253 T5 als Fehlerbeitrag zur Positionsbestimmung i.w. nur Exzentrizitätsfehler auf. Bei rotatorischen, optischen Positionsmesseinrichtungen mit Auflicht-Abtastung liegt darüber hinausgehend ein weiterer Fehlerbeitrag vor, der durch eine eventuelle Taumelbewegung der Gitter-Maßverkörperung bzw. Teilscheibe hervorgerufen wird. Eine derartige Taumelbewegung kann auftreten, wenn die Teilscheibe in der jeweiligen Messanordnung nicht korrekt gelagert oder montiert ist.

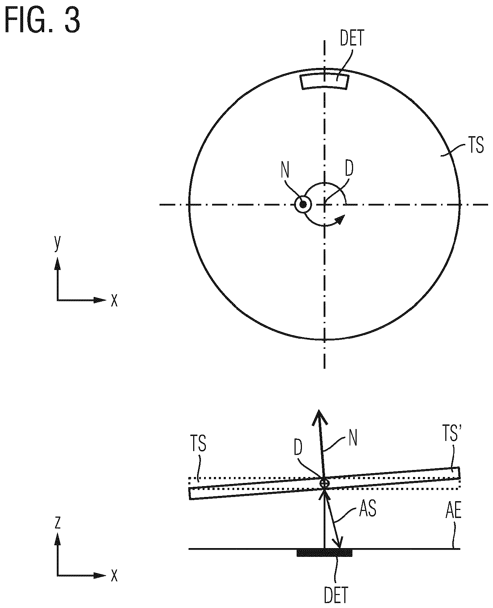

Den Einfluss einer im Auflicht abgetasteten taumelnden Teilscheibe auf die Positionsmessung sei zunächst anhand der schematischen Darstellungen in Figur 3 erläutert; die obere Darstellung zeigt hierbei eine Draufsicht auf die Teilscheibe TS, die untere Darstellung eine Seitenansicht der Positionsmesseinrichtung. Strichliniert ist im unteren Teil der Figur dabei die korrekt montierte Teilscheibe TS ohne Taumelbewegung dargestellt, durchgezogen die um den Drehpunkt D verkippte und damit taumelnde Teilscheibe TS'.

In der Seitenansicht ist in Figur 3 die taumelnde Teilscheibe TS' durch einen in dieser Projektion schief stehenden Normalenvektor N verdeutlicht. Die lichtempfindliche Fläche der Detektionseinheit DET befindet sich in der Abtastebene AE, wobei die nur schematisch angedeuteten Abtastungs-Strahlenbündel AS, die von einer - nicht gezeigten - Lichtquelle in der Detektionseinheit DET emittiert werden, von der im dargestellten Zustand schief stehenden Teilscheibe TS' reflektiert werden und ein über die Abtastung erzeugtes Lichtmuster versetzt auf die Detektionseinheit DET auftrifft. Dies bewirkt, dass die Detektionseinheit DET eine von der wahren Position versetzte, also eine abweichende Position erfasst. Dreht sich nun die Teilscheibe TS, so beschreibt die Spitze des Normalenvektors N der Teilscheibe TS eine Kreisbahn um den Drehpunkt D, wie dies im oberen Teil der Figur 3 gezeigt ist.

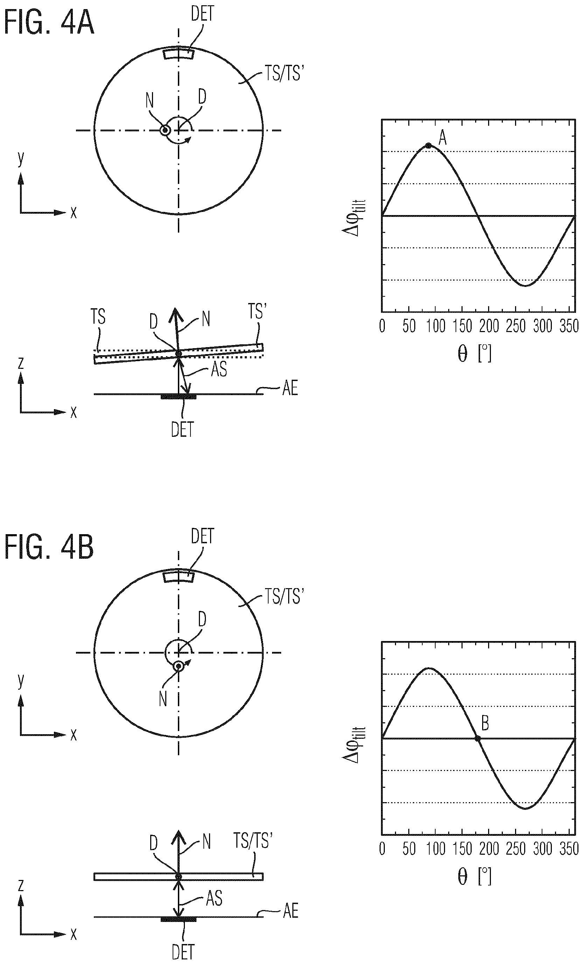

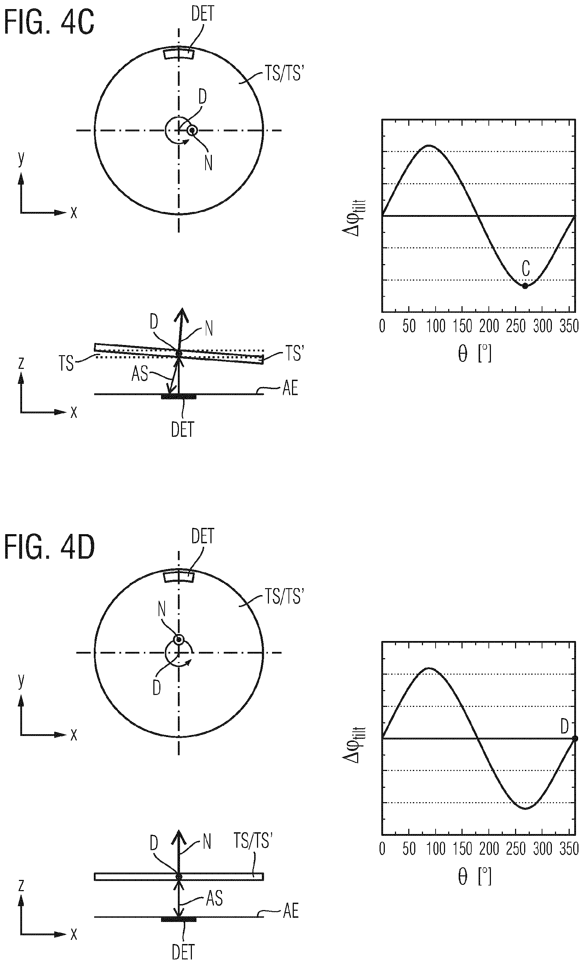

Analog zur obigen Diskussion der Figuren 1A - 1D lässt sich auch der Einfluss einer eventuellen Taumelbewegung der Teilscheibe TS auf den resultierenden Messfehler darstellen. Dies ist in den Figuren 4A - 4D veranschaulicht.

In den Rotations-Stellungen A und C der Teilscheibe TS ist wie aus den Figuren ersichtlich der taumelbedingte Drehwinkel-Fehler $\Delta\varphi_{tilt}$ maximal; in den Rotations-Stellungen B und D hingegen, in denen nur eine radiale Verschiebung des Lichtmusters vorliegt, verschwindet der taumelbedingte Drehwinkel-Fehler $\Delta\varphi_{tilt}$.

Der Drehwinkel-Fehler $\Delta\varphi_{tilt}$, verursacht durch die Taumelbewegung der Teilscheibe TS, ist bei einer Auflichtabtastung gegeben durch:

$$\Delta\varphi_{tilt} = b \cdot sin(\theta + \Delta\theta_2) \qquad (Gl.\ 7)$$

mit:

    $\Delta\varphi_{tilt}$ := taumelbedingter Drehwinkel-Fehler
    b := Amplitude des taumelbedingten Drehwinkel-Fehlers
    $\theta$ := Drehwinkel der Teilscheibe
    $\Delta\Theta_2$ := Phasenlage des taumelbedingten Drehwinkel-Fehlers

Insgesamt ergibt sich der Gesamt-Messfehler $\Delta\varphi_{total}$ bei der Positionsbestimmung dann aus der Summe der exzentrizitäts- und taumelbedingten Anteile am Drehwinkel-Fehler $\Delta\varphi_{exz}$, $\Delta\varphi_{tilt}$ gemäß den Beziehungen 3) und 7) folgendermaßen:

$$\Delta\varphi_{total} = \Delta\varphi_{exz} + \Delta\varphi_{tilt} = a \cdot sin(\theta + \Delta\theta_1) + b \cdot sin(\theta + \Delta\theta_2) \quad (Gl.\ 8)$$

mit:

    $\Delta\varphi_{total}$ := Gesamt-Messfehler
    $\Delta\varphi_{exz}$ := exzentrizitätsbedingter Drehwinkel-Fehler
    $\Delta\varphi_{tilt}$ := taumelbedingter Drehwinkel-Fehler
    a := e/R := Amplitude des exzentrizitätsbedingten Drehwinkel-Fehlers
    b := Amplitude des taumelbedingten Drehwinkel-Fehlers
    $\theta$ := Drehwinkel der Teilscheibe
    $\Delta\Theta_1$ := Phasenlage des exzentrizitätsbedingten Drehwinkel-Fehlers
    $\Delta\Theta_2$ := Phasenlage des taumelbedingten Drehwinkel-Fehlers

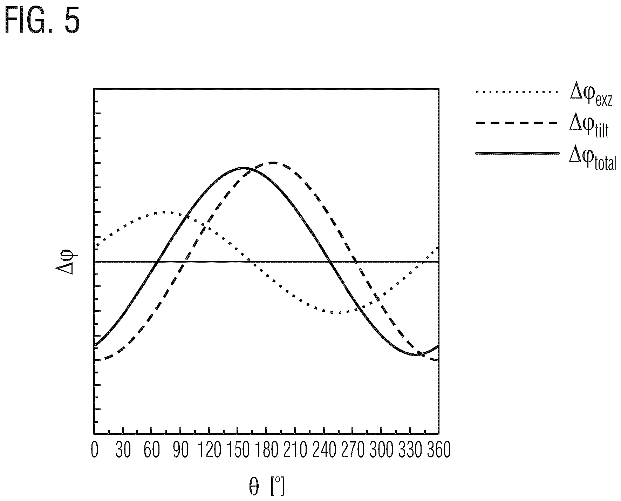

In Figur 5 sind die verschiedenen Anteile am Drehwinkel-Fehler $\Delta\varphi_{exz}$, $\Delta\varphi_{tilt}$ sowie der resultierende Gesamt-Messfehler $\Delta\varphi_{total}$ gemäß der Beziehung 8) über eine vollständige Teilscheiben-Umdrehung dargestellt. Dabei wurden die Phasenlagen und Amplituden der exzentrizitätsbedingten Drehwinkel-Fehler $\Delta\varphi_{exz}$ und der taumelbedingten Drehwinkel-Fehler $\Delta\varphi_{tilt}$ so gewählt, dass diese nicht übereinstimmen und dadurch auch die Phasenlage des Gesamt-Messfehlers $\Delta\varphi_{total}$ unterschiedlich von den Phasenlagen der verschiedenen Fehleranteile ist. Wie aus Figur 5 erkennbar, besitzt auch der resultierende Gesamt-Messfehler $\Delta\varphi_{total}$ eine Periodizität von 360°.

Um gleichzeitig die exzentrizitäts- und taumelbedingten Drehwinkel-Fehler $\Delta\varphi_{exz}$, $\Delta\varphi_{tilt}$ bei der Auflichtabtastung einer rotierenden Gitter-Maßverkörperung zuverlässig korrigieren zu können, sind bestimmte Maßnahmen in Bezug auf die vorgesehenen Abtastungen erforderlich, insbesondere wenn das Korrektur-Konzept gemäß der eingangs diskutierten DE 11 2005 002 253 T5 genutzt werden soll. Maßgeblich hierbei ist dabei die Lage des sogenannten neutralen Drehpunkts der Abtastungen zur Drehwinkel- und Verschiebungsbestimmung. Im folgenden sei zur besseren Verständlichkeit in Verbindung mit zwei unterschiedlichen optischen Abtastungsvarianten erläutert, was unter dem neutralen Drehpunkt einer Abtastung zu verstehen ist.

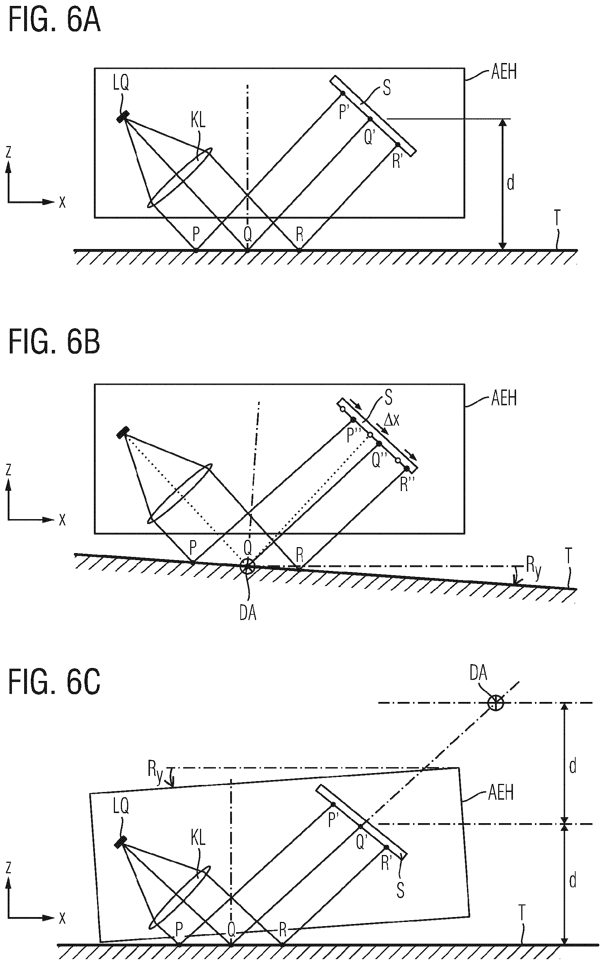

Die Figuren 6A - 6C stellen hierbei den Fall einer ersten optischen Abtastung dar, für das nachfolgend beispielhaft das Konzept des neutralen Drehpunkts einer Abtastung erläutert wird.

Figur 6A zeigt in schematischer Form die optische Abtastung einer reflektierenden Gitter-Maßverkörperung auf einem Maßstab T mittels einer Abtasteinheit AEH. In der Abtasteinheit AEH befindet sich eine Lichtquelle LQ, deren Licht durch eine Kollimator-Linse KL kollimiert wird und dann auf die Gitter-Maßverkörperung auf dem Maßstab T auftrifft. Die vom Maßstab T reflektierten Strahlen gelangen dann auf einen Sensor S in der Abtasteinheit AEH, der im Abtastabstand d oberhalb des Maßstabs T angeordnet ist. Beispielhaft für den Abtastungs-Strahlverlauf seien hier der Zentralstrahl der Kollimatorlinse KL und die beiden Randstrahlen betrachtet, die auf dem Maßstab T auf die Punkte P, Q und R einfallen. Die von den Punkten P, Q und R auf dem Maßstab T reflektierten Strahlen treffen wie gezeigt auf dem Sensor S jeweils auf die Punkte P', Q' und R'.

Im Fall einer Verkippung des Maßstabs T hängt der resultierende Strahlverlauf der jeweiligen Abtastung nunmehr davon ab, um welchen Punkt bzw. um welche Drehachse DA die Abtasteinheit AEH gedreht respektive verkippt wird. Im Fall der Figur 6B befindet sich die Drehachse DA, um die eine Verkippung um einen Winkel $R_y$ resultiert, im Punkt Q und damit auf dem Maßstab T. Da bei der gewählten Abtastung der Einfallswinkel identisch zum Ausfallswinkel ist, trifft bei einer verkippten Anordnung der vom Punkt Q reflektierte Strahl auf dem Sensor S nicht mehr auf den Punkt Q' wie im unverkippten Zustand, sondern um einen Betrag $\Delta x$ versetzt auf den Punkt Q" in der Detektionsebene des Sensors S. Analog hierzu treffen die von den Punkten P und R auf dem Maßstab T reflektierten Strahlen im verkippten Zustand im Sensor S auf die Punkte P" bzw. R". Die Größe des verkippungsbedingten Versatzes $\Delta x$ lässt sich grundsätzlich formelmäßig exakt angeben, spielt aber für die folgenden Betrachtungen keine Rolle. Letztlich bewirkt die Verkippung um die Drehachse DA also, dass der Sensor S einen Positionsversatz detektiert, da das Lichtmuster auf dem Sensor S verkippungsbedingt weitergewandert ist, obwohl sich die Abtasteinheit AEH positionsmäßig unverändert immer noch an der gleichen x-Position befindet.

Um die Bedeutung der jeweiligen Lage der Drehachse DA zu veranschaulichen, um die eine Verkippung resultiert, ist in Figur 6C der Fall dargestellt, wenn sich die Drehachse DA im Abstand 2d von der Oberfläche des Maßstabs T entfernt befindet. Verdreht man die Abtasteinheit AEH nun um einen Winkel $R_y$ um die dort befindliche Drehachse DA, so treffen die an den Punkten P, Q und R auf dem Maßstab T reflektierten Strahlen wie im unverkippten Zustand gemäß Figur 6A auf die Punkte P', Q' und R' auf dem Sensor S. Es wird bei dieser Lage der Drehachse DA also trotz einer Verkippung der Abtasteinheit AEH kein Positionsversatz detektiert.

Es ist demzufolge ersichtlich, dass bei der in den Figuren 6A - 6C gezeigten Abtastung eine Drehachse DA bzw. ein Punkt im System existiert, um die bzw. um den eine Verkippung der Abtasteinheit AEH erfolgen kann, ohne dass dabei eine Positionsänderung bewirkt wird. Die entsprechende Drehachse DA sei nachfolgend als neutrale Drehachse und der entsprechende Punkt als neutraler Drehpunkt bezeichnet. Im erläuterten Beispiel der Figuren 6A - 6C liegt der neutrale Drehpunkt um den doppelten Abtastabstand 2d entfernt von der Oberfläche des Maßstabs T.

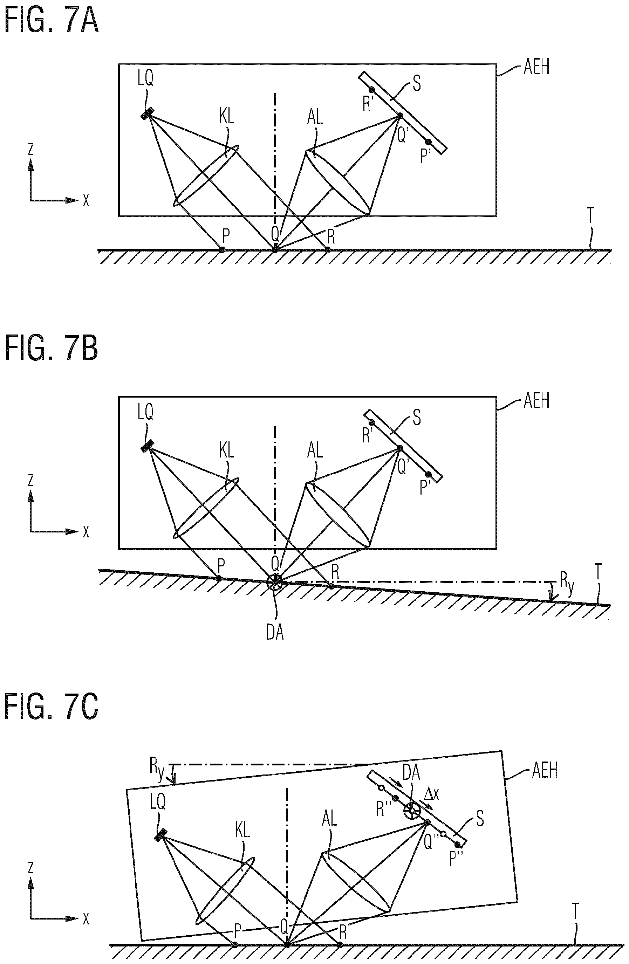

Mit Hilfe der Figuren 7A - 7C wird das Konzept des neutralen Drehpunkts nachfolgend noch beispielhaft in Verbindung mit einer weiteren Abtastung in einer optischen Positionsmesseinrichtung erläutert. Hierbei ist nunmehr keine Schattenwurf-Abtastung vorgesehen, der Maßstab T wird im Unterschied zum vorhergehenden Beispiel durch eine Abbildungslinse AL auf den Sensor S abgebildet. Im dargestellten Beispiel der Figuren 7A - 7C liegt dabei eine 1:-1-Abbildung bzw. eine Bildumkehr vor, so dass die auf dem Maßstab T befindlichen Punkte P, Q und R in umgekehrter Reihenfolge R', Q', P' auf dem Sensor S abgebildet werden. Aus Gründen der besseren Übersichtlichkeit ist in den Figuren nur der Strahlverlauf für den zentralen Punkt Q gezeigt.

In Figur 7B ist dabei der Fall veranschaulicht, in dem die Drehachse DA durch den Punkt Q auf dem Maßstab T verläuft und die Abtasteinheit AEH um den Winkel $R_y$ um die Drehachse DA verkippt wird. Da es sich hier um ein abbildendes System handelt, wird der Punkt Q wieder auf den Punkt Q' im Sensor S abgebildet, ungeachtet der veränderten Beleuchtungsrichtung.

Unterschiedlich hierzu sieht die Situation aus, wenn die Drehachse DA durch den im Sensor S befindlichen Punkt Q' verläuft; in Figur 7C ist eine Verkippung um den Winkel Ry um diese Drehachse DA gezeigt. Da sich das abzubildende Objekt, d.h. der Punkt Q auf dem Maßstab T bei der Verkippung von der optischen Achse der Abbildungslinse AL wegbewegt, wird dieser Punkt Q auf dem Sensor S auch um einen Betrag $\Delta x$ in den Punkt Q' versetzt abgebildet.

Im Beispiel der Abtastung gemäß den Figuren 7A - 7C resultiert also eine andere Lage des neutralen Drehpunkts; hier liegt der neutrale Drehpunkt im Unterschied zum vorhergehenden Beispiel der Figuren 6A - 6C auf dem Maßstab T. Eine Verdrehung oder Verkippung der Abtasteinheit AEH um einen dort befindlichen Punkt verursacht keinen Positionsversatz.

Die beiden erläuterten Beispiele aus den Figuren 6A - 6C und 7A - 7C veranschaulichen, dass der neutrale Drehpunkt in einer optischen Positionsmesseinrichtung eine für jede Abtastungsvariante wichtige geometrische Größe darstellt. Insbesondere zeigen diese beiden Beispiele, dass die neutralen Drehpunkte bei beliebigen Abtastungen nicht notwendigerweise zusammenfallen müssen.

Grundsätzlich lässt sich also festhalten:

- Verkippt man in einer optischen Positionsmesseinrichtung das System um den neutralen Drehpunkt, so bleibt die gemessene Position unverändert.
- Verkippt man das System um einen anderen Punkt, so verändert sich die gemessene Position, ohne dass eine tatsächliche Positionsänderung vorliegt. Eine Verkippung kann hierbei entweder aus einer Verkippung der Abtast- bzw. Detektionseinheit bestehen oder aber aus einer Verkippung der Gitter-Maßverkörperung.

Gemäß der vorliegenden Erfindung soll das aus der DE 11 2005 002 253 T3 bekannte Vorgehen zur Korrektur exzentrizitätsbedingter Fehler in rotatorischen Positionsmesseinrichtungen, basierend auf der in einem Kalibrierbetrieb erfolgenden Messung des drehwinkelabhängigen Radialversatzes der Gitter-Maßverkörperung und die im Messbetrieb erfolgende Korrektur des um 90° versetzten Positionswertes mit dem Radialversatz-Wert auf die Korrektur des Taumelfehlers in einer Auflicht-Abtastung erweitert werden. Die im Kalibrierbetrieb erfolgende radiale Abtastung der Gitter-Maßverkörperung muss dazu sowohl die Exzentrizitätsabweichungen als auch in korrekter Weise die Taumelabweichungen der rotierenden Teilscheibe erfassen.

In diesem Zusammenhang wurde erkannt, dass zur korrekten Erfassung der Taumelbewegung die Positionsverschiebung der azimutalen Abtastung (Messrichtung entlang der x-Achse) durch eine $R_y$-Kippung gleich groß sein muss wie die Positionsverschiebung der radialen Abtastung (Messrichtung entlang der y-Achse) durch eine $R_x$-Kippung. Diese Bedingung folgt aus dem vorgesehenen 90°-Versatz der Korrektur und bedeutet letztlich, dass sich die neutralen Drehpunkte der azimutalen Abtastung und der radialen Abtastung im gleichen Abstand zur Teilscheibe bzw. Gitter-Maßverkörperung befinden müssen. In anderen Worten: Die neutralen Drehpunkte der Abtastungen der Gitter-Maßverkörperung zur Drehwinkel- und Verschiebungsbestimmung müssen in der gleichen Ebene liegen, wobei diese Ebene parallel zur Gitter-Maßverkörperung liegt.

Diese Zusammenhänge lassen sich wie folgt formelmäßig beschreiben:
Zunächst gilt für den gemessenen Drehwinkel-Wert der azimutalen Auflicht-Abtastung in Erweiterung von Beziehung 2):

$$\varphi_{mess}(\theta) = \theta + \Delta\varphi_{exz}(\theta) + \Delta\varphi_{tilt}(\theta) \qquad \text{(Gl. 9)}$$

mit:

$\theta$ := Drehwinkel der Teilscheibe
$\varphi_{mess}(\Theta)$ := Drehwinkel-Wert der azimutalen Abtastung
$\Delta\varphi_{exz}(\Theta)$ := exzentrizitätsbedingter Drehwinkel-Fehler
$\Delta\varphi_{tilt}(\Theta)$ := taumelbedingter Drehwinkel-Fehler

Im Fall der Auflichtabtastung einer reflektierenden Gitter-Maßverkörperung addiert sich zum exzentrizitätsbe-dingten Drehwinkel-Fehler $\Delta\varphi_{exz}(\Theta)$ somit der Fehlerbeitrag durch den taumelbedingten Drehwinkel-Fehler $\Delta\varphi_{tilt}(\Theta)$, der sich folgendermaßen beschreiben lässt:

$$\Delta\varphi_{tilt}(\theta) = \frac{1}{R} \cdot \Delta z_A \cdot R_y(\theta) \qquad \text{(Gl. 10)}$$

mit:

$\theta$ := Drehwinkel der Teilscheibe
$\Delta\varphi_{tilt}(\Theta)$ := taumelbedingter Drehwinkel-Fehler
R := Abtastradius
$\Delta z_a$ := Abstand des neutralen Drehpunkts der Azimut-Abtastung von der Teilscheibe
$R_y(\Theta)$ := Kippung der Teilscheibe um die y-Achse am Abtastort

Aus den Beziehungen 9) und 10) folgt dann:

$$\varphi_{mess}(\theta) = \theta + \Delta\varphi_{exz}(\theta) + \frac{1}{R} \cdot \Delta z_A \cdot R_y(\theta) \qquad \text{(Gl. 11)}$$

mit:

$\theta$ := Drehwinkel der Teilscheibe
$\varphi_{mess}(\Theta)$ := Drehwinkel-Wert der azimutalen Abtastung

$\Delta\varphi_{exz}(\Theta)$ := exzentrizitätsbedingter Drehwinkel-Fehler

R := Abtastradius

$\Delta z_a$ := Abstand des neutralen Drehpunkts der Azimut-Abtastung von der Teilscheibe

$R_y(\Theta)$ := Kippung der Teilscheibe um die y-Achse am Abtastort

Das Koordinatensystem wird hier so gewählt, dass der Mittelpunkt der Teilscheibe im Koordinatenursprung und die azimutale Abtaststelle am Ort mit den Koordinaten x = 0, y = R liegt.

Analog zu Beziehung 9) gilt für den Messwert $\Delta r_{mess}(\Theta)$ der radialen Auflicht-Abtastung:

$$\Delta r_{mess}(\theta) = \Delta r_{exz}(\theta) + \Delta r_{tilt}(\theta) \qquad \text{(Gl. 12)}$$

mit:

$\theta$ := Drehwinkel der Teilscheibe

$\Delta r_{mess}(\Theta)$ := Messwert der radialen Auflicht-Abtastung

$\Delta r_{exz}(\Theta)$ := exzentrizitätsbedingter radialer Messwert

Für die Größe $\Delta r_{tilt}(\Theta)$, d.h. für den taumelbedingten radialen Messwert, gilt dabei:

$$\Delta r_{tilt}(\theta) = \Delta z_R \cdot R_x(\theta) \qquad \text{(Gl. 13)}$$

mit:

$\theta$ := Drehwinkel der Teilscheibe

$\Delta r_{tilt}(\Theta)$ := taumelbedingter radialer Messwert

$\Delta z_R$ := Abstand des neutralen Drehpunkts der radialen Abtastung von der Teilscheibe

$R_x(\Theta)$ := Kippung der Teilscheibe um die x-Achse am Abtastort

Zu beachten ist, dass der Messwert der radialen Auflicht-Abtastung $\Delta r_{mess}(\Theta)$ gemäß Beziehung 12) sowohl die tatsächlich exzentrizitätsbedingte radiale Auslenkung der Teilscheibe $\Delta r_{exz}(\Theta)$ beinhaltet als auch die taumelbedingte radiale Verschiebung des Lichtmusters , die hier $\Delta r_{tilt}(\Theta)$ genannt und im Folgenden als taumelbedingter radialer Messwert bezeichnet wird.

Aus den Beziehungen 12) und 13) folgt dann:

$$\Delta r_{mess}(\theta) = \Delta r_{exz}(\theta) + \Delta z_R \cdot R_x(\theta) \qquad \text{(Gl. 14)}$$

mit:

$\theta$ := Drehwinkel der Teilscheibe

$\Delta r_{mess}(\Theta)$ := Messwert der radialen Auflicht-Abtastung

$\Delta r_{exz}(\Theta)$ := exzentrizitätsbedingter radialer Messwert

$\Delta z_R$ := Abstand des neutralen Drehpunkts der radialen Abtastung von der Teilscheibe

$R_x(\Theta)$ := Kippung der Teilscheibe um die x-Achse am Abtastort

Die Taumelbewegung der Teilscheibe wird durch die nachfolgende Beziehung beschrieben:

$$R_x(\theta) = R_y(\theta + \tfrac{\pi}{2}) \qquad \text{(Gl. 15)}$$

mit:

$\theta$ := Drehwinkel der Teilscheibe

$R_x(\Theta)$ := Kippung der Teilscheibe um die x-Achse am Abtastort

$R_y(\Theta)$ := Kippung der Teilscheibe um die y-Achse am Abtastort

EP 3 764 064 B1

Teilt man Beziehung 14) durch R und setzt Beziehung 5) und Beziehung 15) in Beziehung 14) ein, so ergibt sich

$$\frac{1}{R} \cdot \Delta r_{mess}(\theta) = \Delta \varphi_{exz}\left(\theta + \frac{\pi}{2}\right) + \frac{1}{R} \cdot \Delta z_R \cdot R_y\left(\theta + \frac{\pi}{2}\right) \qquad (Gl.\ 16)$$

Eine Exzentrizitäts- und Taumelkorrektur gemäß dem vorstehend beschriebenen Verfahren setzt grundsätzlich voraus, dass bei der Azimut-Abtastung (Beziehung 11) und bei der Radialabtastung (Beziehung 16) die Taumel-Beiträge identisch sind, also:

$$\Delta z_R = \Delta z_A \qquad (Gl.\ 17)$$

mit:

$\Delta z_a$ := Abstand des neutralen Drehpunkts der Azimut-Abtastung von der Teilscheibe
$\Delta z_R$ := Abstand des neutralen Drehpunkts der radialen Abtastung von der Teilscheibe

Eine vollständige Winkel-Korrektur von Exzentrizitäts- und Taumelabweichungen kann dann analog zu Beziehung 6) gemäß der Beziehung

$$\varphi_{korr}(\theta) = \frac{1}{R} \cdot \Delta r_{mess}(\theta) \qquad (Gl.\ 18)$$

erfolgen, mit:

$\theta$ := Drehwinkel der Teilscheibe
$\varphi_{korr}(\Theta)$ := drehwinkelabhängiger Korrekturwert
$R$ := Abtastradius
$\Delta r_{mess}(\Theta)$ := Messwert der radialen Auflicht-Abtastung

In der Praxis kann der Winkel $\theta$ näherungsweise wieder durch den gemessenen (fehlerhaften) Winkelwert $\varphi_{mess}(\Theta)$ ersetzt werden. Für die ausgegebene, korrigierte Winkelposition $\varphi_{out}$ ergibt sich damit:

$$\varphi_{out} = \varphi_{mess} - \varphi_{korr}\left(\varphi_{mess} - \frac{\pi}{2}\right) \qquad (Gl.\ 19)$$

mit:

$\varphi_{out}$ := ausgegebene, korrigierte Winkelposition
$\varphi_{mess}(\Theta)$ := Drehwinkel-Wert der azimutalen Abtastung
$\varphi_{korr}(\Theta)$ := drehwinkelabhängiger Korrekturwert

Wird die obige Beziehung 17) bezüglich gleicher Abstände der neutralen Drehpunkte beider Abtastungen von der Teilscheibe bzw. Gitter-Maßverkörperung nicht eingehalten, so wird durch die beschriebene Korrektur zwar der exzentrizitätsbedingte Drehwinkel-Fehler $\Delta\varphi_{exz}(\Theta)$ kompensiert, nicht aber der taumelbedingte Drehwinkel-Fehler $\Delta\varphi_{tilt}(\Theta)$; vgl. Figur 5. Der verbleibende Restfehler ist insbesondere dann groß, wenn eine kostengünstige Fertigung der Welle und/oder der Teilscheiben-Nabe mit entsprechend großen Toleranzen gewünscht ist und damit große Taumelbewegungen auftreten.

Zusammengefasst lässt sich die erfindungsgemäße optische Positionsmesseinrichtung zur Erfassung des Drehwinkels zwischen zwei zueinander rotatorisch beweglichen Objekten folgendermaßen charakterisieren:
So weist die entsprechende Positionsmesseinrichtung eine rotierende Teilscheibe mit einer Gitter-Maßverkörperung auf, die als Reflexionsgitter ausgebildet ist. Aus deren Abtastung sind sowohl Positionsinformationen bezüglich einer azimutalen Drehbewegung um die Drehachse als auch bezüglich einer radialen Verschiebung der Gitter-Maßverkörperung zu gewinnen. Mindestens eine Detektionseinheit dient zur Abtastung der rotierenden Gitter-Maßverkörperung, um den azimutalen Drehwinkel sowie eine radiale Verschiebung der Gitter-Maßverkörperung zu bestimmen. Hierbei wird in einem Kalibrierbetrieb mit Hilfe einer geeignet soft- und/oder hardwaremäßig ausgebildeten Signalverarbeitungseinheit drehwinkelabhängig die radiale Verschiebung der Teilscheibe über eine Umdrehung ermittelt, nachdem die Teilscheibe sowie die Detektionseinheiten in der jeweiligen Anwendung montiert wurden. Die hierbei gewonnenen Messwerte zur Radialverschiebung der Teilscheibe werden dann in einem Speicher der Signalverarbeitungseinheit in Tabellenform abgespeichert; dabei kann eine entsprechende Korrekturkurve beispielsweise auch in Form von Stützstellen abgespeichert werden. Im Messbetrieb wird der gemessene Drehwinkel-Wert der azimutalen Abtastung über die Signalverarbeitungseinheit mit dem um 90° versetzten Korrekturwert aus dem Speicher z.B. gemäß Beziehung 19) um exzentrizitäts- und taumelbedingte Fehler korrigiert und eine korrigierte Winkelposition $\varphi_{out}$ ausgegeben. Die Korrektur kann hierbei auch durch eine lineare Interpolation zwischen den im Speicher abgelegten Stützstellen erfolgen. Statt einer Korrektur über Stützstellen kann eine Korrektur alternativ auch über eine sinus- oder cosinusförmige Korrekturfunktion erfolgen, wobei deren Amplitude und Phasenlage aus den Messwerten $\Delta r_{mess}$ und einen entsprechenden Fit bestimmt werden müsste. Zu diesem Vorgehen und insbesondere der gewünschten Taumel-Kompensation bei Auflichtabtastungen ist erforderlich, dass die neutralen Drehpunkte der Abtastungen der Gitter-Maßverkörperung zur Drehwinkel- und Verschiebungsbestimmung in der gleichen Ebene und parallel zur Gitter-Maßverkörperung liegen. Ist dies nicht gewährleistet, würde die ausgegebene Winkelposition $\varphi_{out}$ ansonsten zu wenig oder zu viel korrigiert.

In den Figuren 8A und 8B ist das Vorgehen im Kalibrierbetrieb (Figur 8A) sowie im Messbetrieb (Figur 8B) für ein Ausführungsbeispiel einer erfindungsgemäßen optischen Positionsmesseinrichtung stark schematisiert dargestellt.

Gemäß Figur 8A werden im Kalibrierbetrieb, während sich die Teilscheibe bzw. Gitter-Maßverkörperung um eine vollständige Umdrehung dreht, in den Verfahrensschritten S10a, S10b, über die entsprechenden Abtastungen die Signale zur radialen Verschiebung und zum Drehwinkel der Teilscheibe erzeugt; die entsprechenden Signale seien nachfolgend mit $S_r$ (radiale Verschiebung) und $S_\varphi$ (azimutaler Drehwinkel) bezeichnet. Daraufhin werden in den Verfahrensschritten S11a, S11b die erzeugten Signale $S_r$, $S_\varphi$ in einer geeignet ausgebildeten Signalverarbeitungseinheit interpoliert und in entsprechende Positionssignale $\Delta r_{mess}$, $\varphi_{mess}$ umgeformt, wobei $\Delta r_{mess}$ den Positionswert der Radialmessung und $\varphi_{mess}$ den Positionswert der Azimutalmessung bezeichnet. Im anschließenden Verfahrensschritt S12 wird dann in einem Speicher der Signalverarbeitungseinheit eine Korrektur-Tabelle befüllt, wozu ein Korrekturwert $\varphi_{korr}(\theta)$ für jeden Winkel $\theta$ berechnet wird, der zur Korrektur der exzentrizitäts- und taumelbedingten Drehwinkel-Fehler dient. Selbstverständlich können die Korrekturwerte $\varphi_{korr}(\theta)$ dabei auch nur an bestimmten Stützpunkten über den Umfang der Teilscheibe aufgenommen werden.

Im Verfahrensschritt S12 können auch aus den an bestimmten Stützstellen aufgenommenen Positionssignalen $\Delta r_{mess}$, $\varphi_{mess}$ durch einen Fit Parameter einer (beispielsweise sinusförmigen) Korrekturfunktion wie Amplitude und Phase gewonnen werden.

In Figur 8B ist der Messbetrieb einer erfindungsgemäßen Positionsmesseinrichtung stark schematisiert dargestellt. Wie daraus ersichtlich, erfolgt im Messbetrieb keine Erfassung der Radialverschiebung der Teilscheibe mehr, gemäß dem Verfahrensschritt S20 ist lediglich die Erzeugung von Signalen $S_\varphi$ bezüglich des azimutalen Drehwinkels der Teilscheibe vorgesehen. Die Signale $S_\varphi$ werden im Verfahrensschritt S21 über die Signalverarbeitungseinheit interpoliert und in Positionssignale $\varphi_{mess}$ umgeformt. Im Verfahrensschritt S22 wird über die Signalverarbeitungseinheit unter Zuhilfenahme der Korrekturwerte $\varphi_{korr}(\theta)$ gemäß der angegeben Beziehung aus dem Verfahrensschritt S12 des Kalibrierbetriebs bzw. einer Korrekturfunktion dann der Korrekturwert $\varphi_{korr}$ für den jeweiligen Drehwinkel $\Theta$ ermittelt und im Verfahrensschritt S23 zusammen mit dem Messwert $\varphi_{mess}$ zur ausgegebenen korrigierten Winkelposition $\varphi_{out}$ gemäß der angegebenen Beziehung verrechnet. Da die Korrekturtabelle natürlich nur an endlich vielen Stützstellen befüllt wird, ist für die Ermittlung des Korrekturwerts im Verfahrensschritt S22 im allgemeinen eine Interpolation in üblicher Art und Weise nötig.

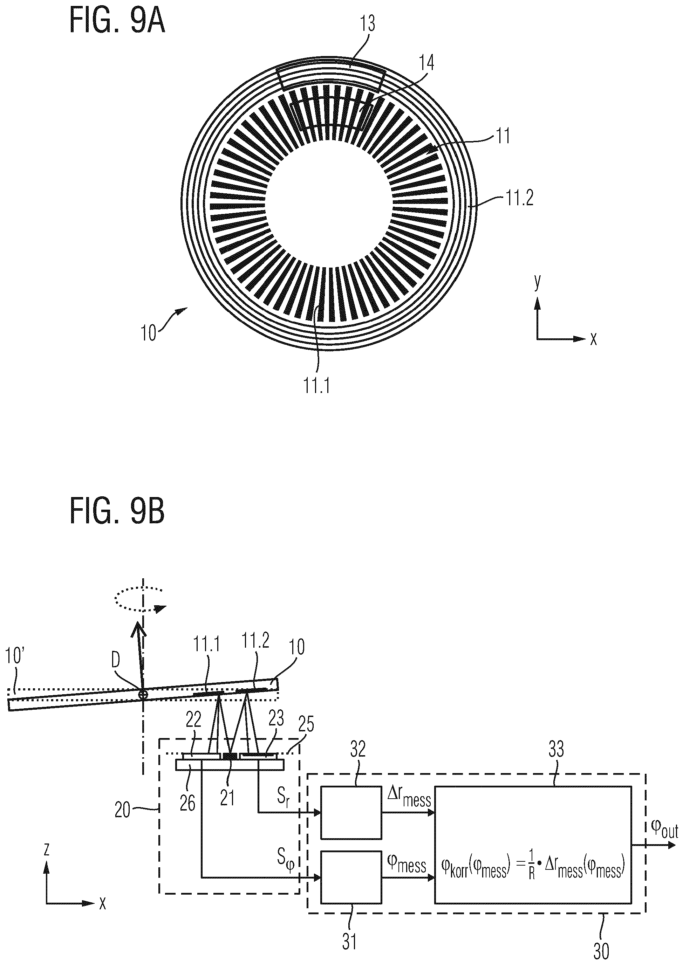

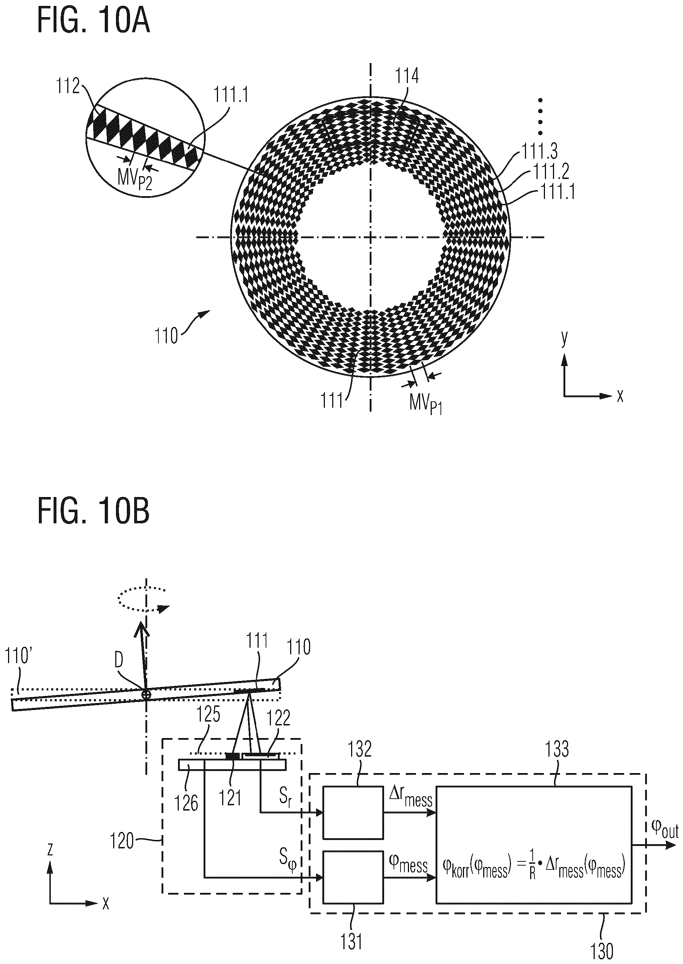

Abschließend werden anhand der stark vereinfachten Figuren 9A, 9B sowie 10A, 10B zwei Ausführungsbeispiele entsprechender optischer Positionsmesseinrichtungen im Detail beschrieben. Die beiden Ausführungsbeispiele unterscheiden sich hierbei zum einen in der jeweils verwendeten Gitter-Maßverkörperung sowie zum anderen in der Abtastung zur Erfassung des azimutalen Drehwinkels und der radialen Verschiebung der Gitter-Maßverkörperung bzw. Teilscheibe.

Das erste Ausführungsbeispiel gemäß den Figuren 9A, 9B nutzt eine Teilscheibe 10 mit einer Gitter-Maßverkörperung, wie sie z.B. aus der DE 11 2005 002 253 T5 bereits bekannt ist. Gemäß der Draufsicht auf die Teilscheibe in Figur A umfasst die als Reflexionsgitter ausgebildete Gitter-Maßverkörperung 11 eine innenliegende Radial-Teilung 11.1 sowie eine außenliegend benachbart hierzu angeordnete Kreisring-Teilung 11.2; die beiden Teilungen 11.1, 11.2 sind hier in zwei separaten, kreisringförmigen Spuren auf der Teilscheibe 10 angeordnet. Die Radial-Teilung 11.1 besteht aus radial orientierten Gitterbereichen mit unterschiedlichen Reflexionseigenschaften für das darauf einfallende Licht, die Kreisring-Teilung 11.2 aus kreisringförmigen Gitterbereichen. Die in der Figur hell dargestellten Gitterbereiche in den verschiedenen Teilungen 11.1, 11.2 sind dabei hochreflektierend ausgebildet, die dunklen Gitterbereiche geringreflektierend. Mit dem Bezugszeichen 13 wird in Figur 9A die Abtaststelle einer ersten Detektionseinheit auf der Radialteilung 11.1 bezeichnet; die erste Detektionseinheit dient im Kalibrier- und Messbetrieb zur Abtastung der Radialteilung 11.1 und zur Messung des azimutalen Drehwinkels $\theta$ der Teilscheibe 10. Das Bezugszeichen 14 bezeichnet in Figur 9A die Abtaststelle einer zweiten Detektionseinheit auf der Kreisringteilung 11.2; die zweite Detektionseinheit dient zur Abtastung der Kreisring-Teilung 11.2 und damit zur Messung der radialen Auslenkung der Teilscheibe 10 im Kalibrierbetrieb.

In Figur 9B ist das erste Ausführungsbeispiel der erfindungsgemäßen Positionsmesseinrichtung in einer schematisierten Seitenansicht gezeigt. Wie daraus ersichtlich, ist die Teilscheibe 10 mit der darauf angeordneten Gitter-Maßverkörperung 11 in Form der Radial- und Kreisringteilung 11.1, 11.2 um den Drehpunkt D verkippt, was bei der Rotation um die Drehachse eine Taumelbewegung der Teilscheibe 10 zur Folge hat. Strichliniert ist in Figur 9B die unverkippte Teilscheibe 10' im Fall der idealen Anordnung angedeutet. Ebenfalls in Figur 9B erkennbar, ist die einer Abtasteinheit 20 zugeordnete erste Detektionseinheit 22, die zur Abtastung der Radialteilung 11.1 dient; mit dem Bezugszeichen 23 wird eine zweite Detektionseinheit bezeichnet, die zur Abtastung der Kreisring-Teilung 11.2 dient. Die beiden Detektionseinheiten 22, 23 umfassen jeweils optoelektronische Detektoren, beispielsweise ausgebildet als strukturierte Fotodetektoren. Im vorliegenden Ausführungsbeispiel teilen sich beide Detektionseinheiten 22, 23 eine mittig in der Abtasteinheit 20 auf einer Platine 26 angeordnete Lichtquelle 21, die Strahlenbündel divergent in Richtung der Teilscheibe 10 emittiert, wo die Strahlenbündel von den beiden Spuren der Gitter-Maßverkörperung 11 dann auf die beiden Detektionseinheiten 22, 23 zurückreflektiert werden.

Desweiteren ist in Figur 9B eine der Positionsmesseinrichtung zugeordnete Signalverarbeitungseinheit 30 schematisiert angedeutet, die u.a. die Weiterverarbeitung der über die Detektionseinheiten 22, 23 erfassten Signale $S_r$, $S_\varphi$ bezüglich der radialen Teilscheibenverschiebung und bezüglich des azimutalen Drehwinkels übernimmt. Über die beiden Interpolationseinheiten 31, 32 können in der Signalverarbeitungseinheit 30 der Messwert $\Delta r_{mess}$ der Radialauslenkung sowie der Messwert $\varphi_{mess}$ bezüglich des Drehwinkels der Teilscheibe 10 im Kalibrier- und Messbetrieb bestimmt und gemäß dem oben erläuterten Vorgehen über die Einheit 33 zu einer ausgegebenen Winkelposition $\varphi_{out}$ weiterverarbeitet werden, die bezüglich Exzentrizität und Taumel korrigiert ist.

Der neutrale Drehpunkt der Abtastung zur Erfassung des azimutalen Drehwinkels über die erste Detektionseinheit 22 liegt in diesem Ausführungsbeispiel erfindungsgemäß in der gleichen Ebene wie der neutrale Drehpunkt der Abtastung zur Erfassung der radialen Auslenkung der Teilscheibe 10 über die zweite Detektionseinheit 23. Konkret liegen beide neutrale Drehpunkte in der Detektionsebene 25 der beiden Detektionseinheiten 22, 23 und damit parallel zur Gitter-Maßverkörperung 11.

Zu erwähnen ist im Zusammenhang mit diesem Ausführungsbeispiel noch, dass die radiale Abtastung durch die in radialer Messrichtung geneigte Beleuchtungsrichtung keinen zusätzlichen Messfehler durch die mit dem Taumel der Teilscheibe 10 einhergehenden Abstandsänderungen erfährt. Dies ist durch die in der Detektionsebene 25 angeordnete, divergente Lichtquelle 21 sichergestellt.

Ein weiteres Ausführungsbeispiel einer erfindungsgemäßen optischen Positionsmesseinrichtung sei abschließend anhand der Figuren 10A und 10B erläutert, die analog zum vorhergehenden Beispiel wiederum die Draufsicht auf die Teilscheibe 110 sowie eine Seitenansicht einer erfindungsgemäßen Positionsmesseinrichtung in Verbindung mit weiteren Komponenten derselbigen zeigen. Nachfolgend werden lediglich die maßgeblichen Unterschiede zum ersten Ausführungsbeispiel erläutert, ansonsten sei auf die Beschreibung des ersten Ausführungsbeispiels und die Figuren 9A und 9B verwiesen.

Im Hinblick auf die in diesem Ausführungsbeispiel verwendete Gitter-Maßverkörperung 111 und die zugehörige Abtast- bzw. Detektionseinheit wird an dieser Stelle auf den Offenbarungsgehalt der deutschen Patentanmeldung Nr. 102018200449.8 Bezug genommen.

Gemäß Figur 10A ist im zweiten Ausführungsbeispiel eine gegenüber der vorher erläuterten Variante unterschiedlich ausgebildete Gitter-Maßverkörperung 111 vorgesehen, die in einer kreisringförmigen Spur auf der Teilscheibe 110 angeordnet ist. Mit dem Bezugszeichen 14 wird in Figur 10A die einzig vorgesehene Abtaststelle dieses Ausführungsbeispiels bezeichnet. Die wiederum als Reflexionsgitter ausgebildete Gitter-Maßverkörperung 111 besteht hierbei aus kreisringförmig und periodisch mit einer ersten Maßverkörperungs-Periodizität $MV_{P1}$ angeordneten Streifenelementen 111.1, 111.2, 111.3,...., deren Längserstreckungsrichtung radial orientiert ist. Die Streifenelemente 111.1, 111.2, 111.3,... besitzen zur Absolutpositionscodierung entlang ihrer Längserstreckungsrichtung ferner eine periodische Struktur mit Strukturelementen 112, die eine zweite Maßverkörperungs-Periodizität $MV_{P2}$ aufweisen. Zur Absolutpositionscodierung der Streifenelemente 111.1, 111.2, 111.3,... kann beispielsweise die Phasenlage der Strukturelemente 112 dienen, um auf diese Art und Weise jedem Streifenelement 111.1, 111.2, 111.3,... einen bestimmten Codewert zuordnen zu können Über die Umfangsrichtung können so Codesequenzen ausgebildet werden, die eine Winkelposition innerhalb von 360° eindeutig charakterisieren.

Die in Figur 10A dunkel dargestellten Gitterbereiche der Gitter-Maßverkörperung 111 sind im Unterschied zum vorhergehenden Ausführungsbeispiel hochreflektierend ausgebildet, die hellen Gitterbereiche geringreflektierend.

Analog zum vorherigen Ausführungsbeispiel ist in Figur 10B das zweite Ausführungsbeispiel der erfindungsgemäßen Positionsmesseinrichtung in einer schematisierten Seitenansicht gezeigt. Wie aus der Figur ersichtlich, ist nunmehr abtastseitig lediglich eine Detektionseinheit in der Abtasteinheit 120 zur Abtastung der in einer Spur angeordneten Gitter-Maßverkörperung 111 vorgesehen. Die Detektionseinheit umfasst dabei lediglich eine divergente Lichtquelle 121, z.B. eine LED, sowie eine einzige Detektoranordnung 122, welche entlang mindestens einer Richtung periodisch ausgebildet ist. Die Lichtquelle 121 ist in der Abtasteinheit 120 benachbart zur Detektoranordnung 122 auf einer Leiterplatte 126 angeordnet.

Zur optischen Abtastung der Gitter-Maßverkörperung 111 ist vorliegend eine Zentralprojektions-Abtastung mit dem Abbildungsmaßstab β = 2 vorgesehen. Hierbei wird das von der Lichtquelle 121 emittierte Licht von der Gitter-Maßverkörperung 111 in die Detektionsebene der Detektoranordnung 122 zurückreflektiert. Der Abbildungsmaßstab β = 2 ist dann gegeben, wenn der Abstand von der Lichtquelle 121 zur Gitter-Maßverkörperung 111 genau gleich dem Abstand von der Ebene der Gitter-Maßverkörperung 111 zur Detektionsebene ist. In diesem Fall werden die Strukturen auf der Gitter-Maßverkörperung 111 genau doppelt so groß auf die Detektoranordnung 122 projiziert. Diesbezüglich sei ergänzend auf die Beschreibung der Figuren 6 und 7 der vorstehend erwähnten deutsche Patentanmeldung Nr. 102018200449.8 verwiesen.

Natürlich kann in einer abgewandelten Variante auch ein anderer Abbildungsmaßstab β ≠ 2 gewählt werden, nämlich dann, wenn die Emissionsebene der Lichtquelle sich nicht genau in der Detektionsebene befindet.

Wie im ersten Ausführungsbeispiel gewährleistet die in der Detektionsebene angeordnete, divergente Lichtquelle, dass die Abstandsänderungen durch die Taumelbewegung der Teilscheibe keine zusätzlichen Messfehler ergeben.

In einer bevorzugten Ausführungsform ist die Detektoranordnung 122 als zweidimensionale Detektoranordnung mit einer Mehrzahl von Detektorelementen ausgebildet, die mehrere Detektorspalten mit jeweils mehreren Detektorelementen aufweist. Die Detektorspalten sind hierbei entlang der kreisringförmigen Anordnungsrichtung mit einer ersten Detektions-Periodizität periodisch angeordnet, während die Detektorelemente in den Detektorspalten mit einer zweiten Detektions-Periodizität periodisch angeordnet sind. Auch hierzu sei ergänzend ausdrücklich auf die o.g. deutsche Patentanmeldung Nr. 102018200449.8 verwiesen.

In diesem Ausführungsbeispiel ermöglicht die vorgesehene Abtastung die Erfassung des azimutalen Drehwinkels der Teilscheibe 110 sowie die Erfassung der radialen Auslenkung der Teilscheibe 110 aus einer einzigen Spur der Gitter-Maßverkörperung 111 auf der Teilscheibe. Diesbezüglich sei ebenfalls ausdrücklich auf die Beschreibung der Figuren 8a und 8b aus der Erläuterung der deutschen Patentanmeldung Nr. 102018200449.8 verwiesen, wo die Gewinnung von Informationen bezüglich eines tangentialen bzw. radialen Versatzes von Teilscheibe und Abtasteinheit mittels einer derartigen Abtastung beschrieben wird.

Die neutralen Drehpunkte im Zusammenhang mit der Drehwinkel-Erfassung und der Verschiebungs-Erfassung der Teilscheibe 110 fallen damit zusammen; konkret liegt der neutrale Drehpunkt hier in der Detektionsebene 125 der Detektoranordnung 122.

Das Vorgehen zur Korrektur der exzentrizitäts- und taumelbedingten Drehwinkel-Fehler aus den erfassten Signalen $S_r$, $S_\varphi$ bezüglich der radialen Teilscheibenverschiebung und bezüglich des azimutalen Drehwinkels erfolgt ansonsten wie im vorher erläuterten Beispiel.

Neben den konkret beschriebenen Ausführungsbeispielen existieren im Rahmen der vorliegenden Erfindung selbstverständlich noch weitere Ausgestaltungsmöglichkeiten.

So ist es auch möglich, dass die Korrekturwerte nicht nur während des Kalibrierbetriebs aufgenommen werden, sondern auch während des Messbetriebs ständig aktualisiert werden. Dazu müssen auch während des Messbetriebs die radialen Messwerte bestimmt und die Korrekturwerte entsprechend angepasst werden. Diese Anpassung kann entweder unmittelbar in voller Größe oder abgedämpft durch Mittelung mit zurückliegenden Korrekturwerten erfolgen.

Es ist weiterhin möglich, dass die radiale Abtastung und die azimutale Abtastung nicht an der selben azimutalen Position erfolgt. In einem solchen Fall findet die durch die Beziehung 19) beschriebene Korrektur dann nicht um 90° versetzt statt, sondern um einen entsprechenden anderen Wert usw..

**Patentansprüche**

1.   Optische Positionsmesseinrichtung zur Erfassung des Drehwinkels zwischen zwei zueinander rotatorisch beweglichen Objekten, mit

   - einer um eine Drehachse rotierenden Gitter-Maßverkörperung (11; 111), die als Reflexionsgitter ausgebildet ist und aus deren Abtastung sowohl Positionsinformationen bezüglich einer azimutalen Drehbewegung um die Drehachse als auch bezüglich einer radialen Verschiebung der Gitter-Maßverkörperung (11; 111) erzeugbar sind,
   - mindestens einer Detektionseinheit zur Abtastung der rotierenden Gitter-Maßverkörperung (11; 111), die dazu eingerichtet ist, eine azimutale Abtastung sowie eine radiale Abtastung durchzuführen, wodurch der azimutale Drehwinkel ($\varphi_{mess}(\Theta)$) sowie eine radiale Verschiebung ($\Delta r_{mess}(\Theta)$) der Gitter-Maßverkörperung (11; 111) bestimmt werden,
   - wobei die neutrale Drehachse der Abtastung der Gitter-Maßverkörperung (11; 111) zur Drehwinkelbestimmung und die neutrale Drehachse der Abtastung der Gitter-Maßverkörperung (11; 111) zur radialen Verschiebungsbestimmung in der gleichen Ebene liegen, wobei diese Ebene parallel zur unverkippten Gitter-Maßverkörperung (11; 111) liegt und eine neutrale Drehachse diejenige Drehachse bezeichnet, um die die Gitter-Maßverkörperung (11; 111) und die Detektionseinheit gegeneinander verkippbar sind und dabei die jeweils gemessene Position unverändert bleibt.

2. Optische Positionsmesseinrichtung nach Anspruch 1, wobei die Gitter-Maßverkörperung (11) eine Radial-Teilung (11.1) sowie eine hierzu benachbart angeordnete Kreisring-Teilung (11.2) umfasst.

3. Optische Positionsmesseinrichtung nach Anspruch 2, mit einer ersten Detektionseinheit (22) zur Abtastung der Radial-Teilung (11.1) und einer zweiten Detektionseinheit (23) zur Abtastung der Kreisring-Teilung (11.2).

4. Optische Positionsmesseinrichtung nach Anspruch 1, wobei die Gitter-Maßverkörperung (111) aus kreisringförmig und periodisch mit einer ersten Maßverkörperungs-Periodizität ($MV_{P1}$) angeordneten Streifenelementen (111.1, 111.2, 111.3,....) besteht, deren Längserstreckungsrichtung radial orientiert ist und wobei die Streifenelemente (111.1, 111.2, 111.3,....) zur Absolutpositionscodierung entlang ihrer Längserstreckungsrichtung eine periodische Struktur mit einer zweiten Maßverkörperungs-Periodizität ($MV_{P2}$) besitzen.

5. Optische Positionsmesseinrichtung nach Anspruch 4, wobei die Detektionseinheit eine einzige Lichtquelle (121) sowie eine einzige Detektoranordnung (122) umfasst.

6. Optische Positionsmesseinrichtung nach Anspruch 5, wobei die Detektoranordnung (122) als zweidimensionale Detektoranordnung mit einer Mehrzahl von Detektorelementen ausgebildet ist und mehrere Detektorspalten mit jeweils mehreren Detektorelementen aufweist, wobei die Detektorspalten entlang der kreisringförmigen Anordnungsrichtung mit einer ersten Detektions-Periodizität periodisch angeordnet sind und die Detektorelemente in den Detektorspalten mit einer zweiten Detektions-Periodizität periodisch angeordnet sind.

7. Optische Positionsmesseinrichtung nach mindestens einem der vorhergehenden Ansprüche, wobei die optische Abtastung der Gittermaßverkörperung (111) als Zentralprojektions-Abtastung mit dem Abbildungsmaßstab $\beta = 2$ ausgebildet ist und eine divergente Lichtquelle (121) sowie eine Detektoranordnung (122) umfasst, welche entlang mindestens einer Richtung periodisch ausgebildet ist.

8. Optische Positionsmesseinrichtung nach mindestens einem der vorhergehenden Ansprüche, mit einer Signalverarbeitungseinheit (30; 130), die derart eingerichtet und ausgebildet ist,

   - dass die in einem Kalibrierbetrieb über mindestens eine vollständige Umdrehung der Gitter-Maßverkörperung (11; 111) gewonnenen, drehwinkelabhängigen Messwerte zu einer radialen Verschiebung ($\Delta r_{mess}(\Theta)$) der Gitter-Maßverkörperung (11; 111) weiterverarbeitet und als drehwinkelabhängige Korrekturwerte ($\varphi_{korr}$) in einem Speicher der Signalverarbeitungseinheit (30; 130) ablegbar sind, und
   - dass im Messbetrieb die im Speicher abgelegten drehwinkelabhängigen Korrekturwerte ($\varphi_{korr}$) von der Signalverarbeitungseinheit (30; 130) herangezogen werden, um den gemessenen azimutalen Drehwinkel ($\varphi_{mess}(\Theta)$) bezüglich vorliegender Exzentrizitäts- und Taumelfehler zu korrigieren.

9. Optische Positionsmesseinrichtung nach Anspruch 8, wobei die Signalverarbeitungseinheit (30; 130) derart eingerichtet und ausgebildet ist, um die im Kalibrierbetrieb gewonnenen, drehwinkelabhängigen Messwerte zu einer radialen Verschiebung ($\Delta r_{mess}(\Theta)$) der Gitter-Maßverkörperung (11; 111) von der Signalverarbeitungseinheit (30; 130) im Messbetrieb zur Korrektur eines um 90° versetzten Drehwinkels bezüglich vorliegender Exzentrizitäts- und Taumelfehler zu nutzen.

10. Optische Positionsmesseinrichtung nach Anspruch 8, wobei die Signalverarbeitungseinheit (30; 130) den Drehwinkel bezüglich vorliegender Exzentrizitäts- und Taumelfehler folgendermaßen korrigiert:

$$\varphi_{out} = \varphi_{mess} - \varphi_{korr}(\varphi_{mess} - \pi/2)$$

mit:

$\varphi_{out}$ := ausgegebene, korrigierte Winkelposition
$\varphi_{mess}(\Theta)$ := Drehwinkel-Wert der azimutalen Abtastung
$\varphi_{korr}(\Theta)$ := drehwinkelabhängiger Korrekturwert

Claims

1. Optical position measurement device for capturing the rotation angle between two objects that are rotationally movable in relation to one another, comprising

   - a grating material measure (11; 111), which rotates about an axis of rotation and is embodied as a reflection grating and from whose scanning position information both with respect to an azimuthal rotational movement about the axis of rotation and also with respect to a radial displacement of the grating material measure (11; 111) are producible,
   - at least one detection unit for scanning the rotating grating material measure (11; 111), which is configured to perform azimuthal scanning and also radial scanning, as a result of which the azimuthal rotation angle ($\varphi_{mess}(\Theta)$) and a radial displacement ($\Delta r_{mess}(\Theta)$) of the grating material measure (11; 111) are determined,
   - wherein the neutral axis of rotation of the scan of the grating material measure (11; 111) for the rotation angle determination and the neutral axis of rotation of the scan of the grating material measure (11; 111) for the radial displacement determination lie in the same plane, wherein this plane is parallel to the non-tilted grating material measure (11; 111) and a neutral axis of rotation designates the axis of rotation about which the grating material measure (11; 111) and the detection unit are tiltable in relation to one another while the respectively measured position remains unchanged.

2. Optical position measurement device according to Claim 1, wherein the grating material measure (11) comprises a radial graduation (11.1) and, arranged adjacent hereto, a circular ring graduation (11.2).

3. Optical position measurement device according to Claim 2, comprising a first detection unit (22) for scanning the radial graduation (11.1) and a second detection unit (23) for scanning the circular ring graduation (11.2).

4. Optical position measurement device according to Claim 1, wherein the grating material measure (111) consists of stripe elements (111.1, 111.2, 111.3,...) which are arranged in the manner of a circular ring and periodically with a first material measure periodicity ($MV_{P1}$) and whose longitudinal extents are oriented radially, and wherein the stripe elements (111.1, 111.2, 111.3,...) have along their longitudinal extents a periodic structure with a second material measure periodicity ($MV_{P2}$) for the purpose of absolute position encoding.

5. Optical position measurement device according to Claim 4, wherein the detection unit comprises a single light source (121) and a single detector arrangement (122).

6. Optical position measurement device according to Claim 5, wherein the detector arrangement (122) is designed in the form of a two-dimensional detector arrangement having a plurality of detector elements and has a plurality of detector columns each with a plurality of detector elements, wherein the detector columns are arranged periodically with a first detection periodicity along the circular-ring-shaped arrangement direction and the detector elements in the detector columns are arranged periodically with a second detection periodicity.

7. Optical position measurement device according to at least one of the preceding claims, wherein the optical scan of the grating material measure (111) takes the form of a central projection scan with the imaging scale $\beta = 2$ and comprises a divergent light source (121) and also a detector arrangement (122), which is embodied periodically along at least one direction.

8. Optical position measurement device according to at least one of the preceding claims, comprising a signal processing unit (30; 130), which is configured and embodied such

   - that the rotation-angle-dependent measurement values obtained in a calibration operation over at least one complete turn of the grating material measure (11; 111) for a radial displacement ($\Delta r_{mess}(\Theta)$) of the grating material measure (11; 111) are processed further and are able to be stored as rotation-angle-dependent correction values ($\varphi_{korr}$) in a memory of the signal processing unit (30; 130), and
   - that, in the measurement operation, the rotation-angle-dependent correction values ($\varphi_{korr}$) stored in the memory are used by the signal processing unit (30; 130) in order to correct the measured azimuthal rotation angle ($\varphi_{mess}(\Theta)$) with respect to any eccentricity and wobble errors that may be present.

9. Optical position measurement device according to Claim 8, wherein the signal processing unit (30; 130) is configured and embodied to use the rotation-angle-dependent measurement values obtained in the calibration operation for a

radial displacement ($\Delta r_{mess}(\Theta)$) of the grating material measure (11; 111) by way of the signal processing unit (30; 130) during the measurement operation for correcting a rotation angle, with a 90° offset, with respect to any eccentricity and wobble errors that may be present.

10. Optical position measurement device according to Claim 8, wherein the signal processing unit (30; 130) corrects the rotation angle as follows with respect to any eccentricity and wobble errors that may be present:

$$\Phi_{out} = \varphi_{mess} - \varphi_{korr} \ (\varphi_{mess} - \pi/2)$$

with:

$\varphi_{out}$ := output, corrected angular position
$\varphi_{mess}(\Theta)$ := rotation angle value of the azimuthal scan
$\varphi_{korr}(\Theta)$ := rotation-angle-dependent correction value


**Revendications**

1. Dispositif optique de mesure de position servant à détecter l'angle de rotation entre deux objets mobiles en rotation l'un par rapport à l'autre, comprenant

   - une mesure matérialisée de réseau (11 ; 111) tournant autour d'un axe de rotation et qui est réalisée sous forme de réseau de réflexion, et dont le balayage permet de produire des informations de position à la fois concernant une rotation azimutale autour de l'axe de rotation et concernant un décalage radial de la mesure matérialisée de réseau (11 ; 111),
   - au moins une unité de détection servant à balayer la mesure matérialisée de réseau (11 ; 111) tournante et qui est conçue pour effectuer un balayage azimutal ainsi qu'un balayage radial de façon à déterminer l'angle de rotation azimutal ($\varphi_{mess}(\Theta)$) ainsi qu'un décalage radial ($\Delta r_{mess}(\Theta)$) de la mesure matérialisée de réseau (11 ; 111),
   - dans lequel l'axe de rotation neutre du balayage de la mesure matérialisée de réseau (11 ; 111) servant à la détermination d'angle de rotation et l'axe de rotation neutre du balayage de la mesure matérialisée de réseau (11 ; 111) servant à la détermination de décalage radial se trouvent dans le même plan, ce plan étant situé en parallèle à la mesure matérialisée de réseau (11 ; 111) sans basculement, et un axe de rotation neutre désignant l'axe de rotation autour duquel la mesure matérialisée de réseau (11 ; 111) et l'unité de détection peuvent basculer l'une par rapport à l'autre et la position mesurée respectivement restant inchangée.

2. Dispositif optique de mesure de position selon la revendication 1, dans lequel la mesure matérialisée de réseau (11) comprend une graduation radiale (11.1) ainsi qu'une graduation d'anneau de cercle (11.2) disposée de manière adjacente à celle-ci.

3. Dispositif optique de mesure de position selon la revendication 2, comprenant une première unité de détection (22) servant à balayer la graduation radiale (11.1) et une deuxième unité de détection (23) servant à balayer la graduation d'anneau de cercle (11.2).

4. Dispositif optique de mesure de position selon la revendication 1, dans lequel la mesure matérialisée de réseau (111) est composée d'éléments de bande (111.1, 111.2, 111.3, ...) disposés en forme d'anneau de cercle et périodiquement avec une première périodicité de mesure matérialisée ($MV_{P1}$) et dont la direction d'extension longitudinale est orientée radialement, et dans lequel les éléments de bande (111.1, 111.2, 111.3, ...) possèdent pour le codage de position absolue le long de leur direction d'extension longitudinale une structure périodique d'une deuxième périodicité de mesure matérialisée ($MV_{P2}$).

5. Dispositif optique de mesure de position selon la revendication 4, dans lequel l'unité de détection comprend une seule source de lumière (121) ainsi qu'un seul agencement de détecteurs (122).

6. Dispositif optique de mesure de position selon la revendication 5, dans lequel l'agencement de détecteurs (122) est réalisé sous la forme d'un agencement de détecteurs bidimensionnel, pourvu d'une pluralité d'éléments détecteurs, et présente plusieurs colonnes de détecteurs avec respectivement plusieurs éléments détecteurs, les colonnes de détecteurs étant disposées périodiquement avec une première périodicité de détection le long de la direction d'agencement en forme d'anneau de cercle, et les éléments détecteurs dans les colonnes de détecteurs sont disposés périodiquement avec une deuxième périodicité de détection.

7. Dispositif optique de mesure de position selon au moins l'une des revendications précédentes, dans lequel le balayage optique de la mesure matérialisée de réseau (111) est réalisé sous forme de balayage de projection centrale avec le grossissement $\beta = 2$ et comprend une source de lumière divergente (121) ainsi qu'un agencement de détecteurs (122) qui est réalisé périodiquement le long d'au moins une direction.

8. Dispositif optique de mesure de position selon au moins l'une des revendications précédentes, comprenant une unité de traitement de signal (30 ; 130) qui est conçue et réalisée de telle sorte

- que les valeurs de mesure dépendant de l'angle de rotation, obtenues dans un mode étalonnage sur au moins un tour complet de la mesure matérialisée de réseau (11 ; 111), sont transformées pour un décalage radial ($\Delta r_{mess}(\Theta)$) de la mesure matérialisée de réseau (11 ; 111) et peuvent être stockées sous forme de valeurs de correction dépendant de l'angle de rotation ($\varphi_{korr}$) dans une mémoire de l'unité de traitement de signal (30 ; 130), et
- qu'en mode mesure, les valeurs de correction dépendant de l'angle de rotation ($\varphi_{korr}$) stockées dans la mémoire sont utilisées par l'unité de traitement de signal (30 ; 130) pour corriger l'angle de rotation azimutal mesuré ($\varphi_{mess}(\Theta)$) quant à des défauts d'excentricité et d'oscillation existants.

9. Dispositif optique de mesure de position selon la revendication 8, dans lequel l'unité de traitement de signal (30 ; 130) est conçue et réalisée de façon à exploiter les valeurs de mesure dépendant de l'angle de rotation, obtenues en mode étalonnage, pour un décalage radial ($\Delta r_{mess}(\Theta)$) de la mesure matérialisée de réseau (11 ; 111) de l'unité de traitement de signal (30 ; 130) en mode mesure pour corriger un angle de rotation décalé de 90° quant à des défauts d'excentricité et d'oscillation existants.

10. Dispositif optique de mesure de position selon la revendication 8, dans lequel l'unité de traitement de signal (30 ; 130) corrige l'angle de rotation quant à des défauts d'excentricité et d'oscillation existants comme suit :

$$\varphi_{out} = \varphi_{mess} - \varphi_{korr} (\varphi_{mess} - \pi/2)$$

où :

$\varphi_{out}$ := la position angulaire corrigée sortie
$\varphi_{mess}(\Theta)$ := la valeur d'angle de rotation du balayage azimutal
$\varphi_{korr}(\Theta)$ := la valeur de correction dépendant de l'angle de rotation.

FIG. 1A

FIG. 1B

FIG. 1C

FIG. 1D

# FIG. 2A

STAND DER TECHNIK

# FIG. 2B

STAND DER TECHNIK

## FIG. 2C

STAND DER TECHNIK

## FIG. 2D

STAND DER TECHNIK

FIG. 3

FIG. 4A

FIG. 4B

# FIG. 4C

# FIG. 4D

FIG. 5

## FIG. 6A

## FIG. 6B

## FIG. 6C

FIG. 7A

FIG. 7B

FIG. 7C

# FIG 8A

# FIG 8B

FIG. 9A

FIG. 9B

$$\varphi_{korr}(\varphi_{mess}) = \frac{1}{R} \cdot \Delta r_{mess}(\varphi_{mess})$$

## FIG. 10A

## FIG. 10B

**IN DER BESCHREIBUNG AUFGEFÜHRTE DOKUMENTE**

**In der Beschreibung aufgeführte Patentdokumente**

- DE 112005002253 T5
- EP 2662666 A2

- US 20070075230 A1
- DE 112005002253 T3
- DE 102018200449